# EUROPEAN PATENT APPLICATION

(11) **EP 2 352 181 A1**
(43) Date of publication of application: **03.08.2011**
(21) Application number: 09820600.6
(22) Date of filing: 14.10.2009
(51) Int. Cl.: H01L 33/00

(54) **NITRIDE-BASED SEMICONDUCTOR LIGHT EMITTING ELEMENT, METHOD FOR MANUFACTURING NITRIDE-BASED SEMICONDUCTOR LIGHT EMITTING ELEMENT, AND LIGHT EMITTING DEVICE**

(30) Priority: 17.10.2008 JP 2008269006; 29.09.2009 JP 2009225350
(71) Applicant: Sumitomo Electric Industries, Ltd., Chuo-ku Osaka-shi Osaka 541-0041 (JP)
(72) Inventor: ENYA Yohei, Itami-shi Hyogo 664-0016 (JP); YOSHIZUMI Yusuke, Itami-shi Hyogo 664-0016 (JP); KYONO Takashi, Itami-shi Hyogo 664-0016 (JP); UENO Masaki, Itami-shi Hyogo 664-0016 (JP); NAKAMURA Takao, Itami-shi Hyogo 664-0016 (JP)
(74) Representative: Grünecker, Kinkeldey, Stockmair & Schwanhäusser Anwaltssozietät
(86) International application number: PCT/JP2009/067782
(87) International publication number: WO 2010/044422

(57) **Abstract**

Disclosed is a nitride-based semiconductor light emitting device with excellent light extraction efficiency. A light emitting device 11 includes a support base 13 and a semiconductor laminate 15. The semiconductor laminate 15 includes an n-type GaN-based semiconductor region 17, an active layer 19, and a p-type GaN-based semiconductor region 21. The n-type GaN-based semiconductor region 17, the active layer 19, and the p-type GaN-based semiconductor region 21 are mounted on a principal surface 13a, and are arranged in the direction of a predetermined axis Ax orthogonal to the principal surface 13a. A rear surface 13b of the support base 13 is inclined with respect to a plane orthogonal to a reference axis extending in the c-axis direction of a hexagonal gallium nitride semiconductor of the support base 13. A vector VC represents the c-axis direction. A surface morphology M of the rear surface 13b has a plurality of protrusions 23 protruding in the direction of a <000-1>-axis. The direction of the predetermined axis Ax is different from the direction of the reference axis (the direction of the vector VC).

## Description

### Technical Field

The present invention relates to a nitride-based semiconductor light emitting device, a method of manufacturing a nitride-based semiconductor light emitting device, and a light emitting apparatus.

### Background Art

Patent Document 1 describes a method of mounting a light emitting apparatus and a light emitting device. According to this method of mounting a light emitting apparatus, an edge of a substrate (light emitting/transmitting surface) and a die pad of a lead frame are partially fixed to each other or an edge of a substrate and a die pad of a lead frame are fixed to each other. A light emitting apparatus having a light emitting device mounted thereon emits generated light from the rear surface of the die pad. The device is provided with a multilayer reflecting layer including a nitride semiconductor on an opposite side to a substrate of a light emitting layer. A multilayer film or an insulator layer and a metal reflecting layer are provided on the upper surface and side surfaces of the device, such that generated light which goes from the light emitting layer toward the upper surface and the side surfaces is reflected toward the substrate.

Patent Document 2 describes a gallium nitride-based compound semiconductor light emitting device. After a gallium nitride-based compound semiconductor is grown on a sapphire substrate, and the sapphire substrate is polished or separated and removed. In this gallium nitride-based compound semiconductor light emitting device, the rear surface of the gallium nitride-based compound semiconductor becomes a nonspecular surface by etching. The sapphire substrate is removed, such that interference at an interface due to a difference in the reflective index between sapphire and gallium nitride is eliminated. Light is diffusely reflected by the nonspecular surface.

Patent Document 3 describes a method of manufacturing a self-standing gallium nitride single-crystal substrate. The degree of contact with a substrate holder is enhanced and warping of the GaN self-standing substrate is reduced, such that the non-defective product yield of a nitride semiconductor device is improved. A front surface (Ga face) of the substrate is polished as a mirror surface, and a rear surface (N face) is lapped and etched, such that an arithmetic mean roughness Ra in a range of not less than 1 µm and not more than 10 µm is made. The rear surface (N face) is in contact with the substrate holder of the vapor deposition apparatus.

### Citation List

### Patent Literature

Patent Document 1 : Japanese Unexamined Patent Application Publication No. 2000-164938
Patent Document 2 : Japanese Unexamined Patent Application Publication No. 2003-69075
Patent Document 3 : Japanese Unexamined Patent Application Publication No. 2007-153712

### Summary of Invention

### Technical Problem

In Patent Document 1, a GaN layer and an AlGaN layer are alternately arranged to form a multilayer reflecting film, and an active layer is disposed between the multilayer reflecting film and the substrate. For this reason, light from the active layer is emitted from the rear surface of the substrate. In Patent Document 2, in order to suppress light reflection at the interface between the gallium nitride-based epitaxial laminate and the sapphire substrate due to the difference in reflective index, the sapphire substrate is removed to expose the rear surface of the gallium nitride-based compound semiconductor. The exposed surface of the gallium nitride-based compound semiconductor of the epitaxial film becomes a nonspecular surface by etching. In Patent Document 3, the degree of contact with the substrate holder is improved and warping of the GaN self-standing substrate is reduced, such that the non-defective product yield of the nitride semiconductor device is improved. For this reason, the rear surface (N face) is lapped and etched, such that the arithmetic mean roughness Ra in a range of not less than 1 µm and not more than 10 µm is made.

The above-described techniques relate to a light emitting device using a sapphire substrate or a light emitting device using a c-plane GaN substrate. These devices are different from a light emitting device using a GaN substrate inclined from the c-plane. In such a surface emission-type nitride-based semiconductor light emitting device on a semi-polar surface, excellent light extraction efficiency is demanded.

It is an object of the invention to provide a nitride-based semiconductor light emitting device with excellent light extraction efficiency, a method of manufacturing a nitride-based semiconductor light emitting device, and a light emitting apparatus including a nitride-based semiconductor light emitting device.

### Solution to Problem

An aspect of the invention provides a nitride-based semiconductor light emitting device. The nitride-based semiconductor light emitting device includes (a) a support base including a hexagonal gallium nitride semiconductor, the support base having a principal surface and a rear surface, and (b) a semiconductor laminate including a p-type gallium nitride-based semiconductor region, an active layer, and an n-type gallium nitride-based semiconductor region. The rear surface of the support base is inclined with respect to a plane orthogonal to a reference axis extending in the c-axis direction of the hexagonal gallium nitride semiconductor. A surface morphology of the rear surface has a plurality of protrusions protruding in the direction of the reference axis. The active layer is provided between the p-type gallium nitride-based semiconductor region and the n-type gallium nitride-based semiconductor region. The p-type gallium nitride-based semiconductor region, the active layer, and the n-type gallium nitride-based semiconductor region are arranged on the principal surface of the support base in the direction of a predetermined axis. The direction of the predetermined axis is different from the direction of the reference axis.

With this nitride-based semiconductor light emitting device, the p-type gallium nitride-based semiconductor region, the n-type gallium nitride-based semiconductor region, and the active layer are mounted on the principal surface of the support base. The rear surface of the support base is inclined with respect to the plane orthogonal to the reference axis extending in the c-axis direction of the hexagonal gallium nitride semiconductor. The direction of the predetermined axis is different from the direction of the reference axis. For this reason, a light component which goes from the active layer toward the substrate is diffusely reflected by the rear surface, such that the travelling direction thereof is changed. The surface morphology of the rear surface has a plurality of protrusions protruding in the direction of the reference axis, so diffuse reflection efficiently occurs at the rear surface, and there is no case where light is trapped in a substrate support base and a semiconductor laminate and lost. Therefore, the nitride-based semiconductor light emitting device has excellent light extraction efficiency.

In the nitride-based semiconductor light emitting device, the principal surface of the support base may be inclined at an angle in a range of not less than 10° and not more than 80° with respect to a <0001>-axis of the hexagonal gallium nitride semiconductor and at an angle in a range of not less than 10° and not more than 80° with respect to a <000-1>-axis of the hexagonal gallium nitride semiconductor. The rear surface of the support base may be inclined at an angle in a range of not less than 10° and not more than 80° with respect to a <000-1>-axis of the hexagonal gallium nitride semiconductor and at an angle in a range of not less than 10° and not more than 80° with respect to a <0001>-axis of the hexagonal gallium nitride semiconductor. With this nitride-based semiconductor light emitting device, the inclination direction of the protrusions is defined in accordance with the above-described inclination angle.

In the nitride-based semiconductor light emitting device, the principal surface of the support base may be inclined at an angle in a range of not less than 10° and not more than 80° with respect to a <0001>-axis of the hexagonal gallium nitride semiconductor, and the rear surface of the support base may be inclined at an angle in a range of not less than 10° and not more than 80° with respect to a <000-1>-axis of the hexagonal gallium nitride semiconductor. With this nitride-based semiconductor light emitting device, the inclination direction of the protrusions is defined in accordance with the above-described inclination angle.

In the nitride-based semiconductor light emitting device, the principal surface of the support base may be inclined at an angle in a range of not less than 55° and not more than 80° with respect to a <0001>-axis of the hexagonal gallium nitride semiconductor, and the rear surface of the support base may be inclined at an angle in a range of not less than 55° and not more than 80° with respect to a <000-1>-axis of the hexagonal gallium nitride semiconductor. With this nitride-based semiconductor light emitting device, the inclination direction of the protrusions is defined in accordance with the above-described inclination angle.

In the nitride-based semiconductor light emitting device, the principal surface of the support base may be inclined at an angle in a range of not less than 10° and not more than 80° with respect to a <000-1>-axis of the hexagonal gallium nitride semiconductor, and the rear surface of the support base may be inclined at an angle in a range of not less than 10° and not more than 80° with respect to a <0001>-axis of the hexagonal gallium nitride semiconductor. With this nitride-based semiconductor light emitting device, the inclination direction of the protrusions is defined in accordance with the above-described inclination angle.

In the nitride-based semiconductor light emitting device, the principal surface of the support base may be inclined at an angle in a range of not less than 55° and not more than 80° with respect to a <000-1>-axis of the hexagonal gallium nitride semiconductor, and the rear surface of the support base may be inclined at an angle in a range of not less than 55° and not more than 80° with respect to a <0001>-axis of the hexagonal gallium nitride semiconductor. With this nitride-based semiconductor light emitting device, the inclination direction of the protrusions is defined in accordance with the above-described inclination angle.

In the nitride-based semiconductor light emitting device, an apex portion of each of the protrusions may have a hexagonal pyramid shape. With this nitride-based semiconductor light emitting device, the apex portion of each of the protrusions has a hexagonal pyramid shape, so light is reflected by surfaces forming a hexagonal pyramid.

In the nitride-based semiconductor light emitting device, the arithmetic mean roughness of the rear surface may be not less than 0.5 µm and not more than 10 µm. With this nitride-based semiconductor light emitting device, an excessively small surface roughness contributes little to extraction efficiency by light diffuse reflection. An excessively large surface roughness contributes little to extraction efficiency by light diffuse reflection.

The nitride-based semiconductor light emitting device may further include a first electrode provided on the semiconductor laminate, and a second electrode provided on the rear surface of the support base. With this nitride-based semiconductor light emitting device, one electrical connection can be made to the semiconductor laminate through the first electrode, and the other electrical connection can be made to the rear surface of the substrate through the second electrode. Alternatively, in the nitride-based semiconductor light emitting device, the semiconductor laminate has a partially exposed region in one of the p-type gallium nitride-based semiconductor region and the n-type gallium nitride-based semiconductor region. The nitride-based semiconductor light emitting device may further include a first electrode provided on the exposed region, and a second electrode provided on the other one of the p-type gallium nitride-based semiconductor region and the n-type gallium nitride-based semiconductor region in the semiconductor laminate.

In the nitride-based semiconductor light emitting device, the active layer may be provided so as to have a peak wavelength in a wavelength range of not less than 350 nm and not more than 650 nm. With this nitride-based semiconductor light emitting device, light in the above-described wavelength range can be diffusely reflected.

In the nitride-based semiconductor light emitting device, light from the active layer may be emitted from an upper surface of the semiconductor laminate. With this nitride-based semiconductor light emitting device, improvement in the diffuse reflectance of the rear surface results in improvement in the light extraction efficiency from the upper surface. In the nitride-based semiconductor light emitting device, light from the active layer may be emitted from a rear surface of the semiconductor laminate. With this nitride-based semiconductor light emitting device, improvement in the diffuse reflectance of the rear surface results in improvement in the light extraction efficiency from the rear surface.

Another aspect of the invention provides a method of manufacturing a surface emission-type nitride-based semiconductor light emitting device. The method includes the steps of (a) preparing a substrate product including a substrate having a principal surface and a rear surface and a semiconductor laminate provided on the principal surface of the substrate, and (b) etching the rear surface of the substrate in the substrate product to form a processed surface having a surface morphology with a plurality of protrusions. The substrate includes a hexagonal gallium nitride semiconductor. The rear surface of the substrate is inclined with respect to a plane orthogonal to a reference axis extending in the c-axis direction of the hexagonal gallium nitride semiconductor. The protrusions protrude in the direction of the reference axis. The semiconductor laminate has a p-type gallium nitride-based semiconductor region, an n-type gallium nitride-based semiconductor region, and an active layer. The active layer is provided between the p-type gallium nitride-based semiconductor region and the n-type gallium nitride-based semiconductor region. The p-type gallium nitride-based semiconductor region, the n-type gallium nitride-based semiconductor region, and the active layer are arranged on the principal surface of the substrate in the direction of a predetermined axis. The direction of the predetermined axis is different from the direction of the reference axis.

With this method, etching is performed on the rear surface of the substrate, such that the processed surface can be formed at the rear surface of the substrate. The processed surface has the surface morphology with a plurality of protrusions. The p-type gallium nitride-based semiconductor region, the n-type gallium nitride-based semiconductor region, and the active layer are mounted on the principal surface of the support base in the direction of the predetermined axis. The rear surface of the support base is inclined with respect to the plane orthogonal to the reference axis extending in the c-axis direction of the hexagonal gallium nitride semiconductor. The direction of the predetermined axis is different from the direction of the reference axis. For this reason, a light component which goes from the active layer toward the substrate is diffusely reflected by the rear surface, such that the travelling direction thereof is changed. The surface morphology of the rear surface has a plurality of protrusions protruding in the direction of the reference axis, so the rear surface diffusely reflects incident light. Therefore, a method of manufacturing a nitride-based semiconductor light emitting device with excellent light extraction efficiency is provided.

In the method, the rear surface of the substrate may be inclined at an angle in a range of not less than 10° and not more than 80° with respect to a <000-1>-axis of the hexagonal gallium nitride semiconductor. With this method, the inclination direction of the protrusions is defined in accordance with the above-described inclination angle.

The method may further include a step of grinding the rear surface of the gallium nitride semiconductor wafer to form the substrate of the substrate product. With this method, a substrate having a desired thickness can be obtained by grinding. In addition, etching can be performed on the grinded surface to form a processed surface.

In the method, the processed surface may be formed by wet etching. With this method, wet etching can be used so as to form a plurality of protrusions.

In the method, the processed surface may be formed by alkali solution. With this method, a plurality of protrusions can be formed by using alkali solution.

In the method, an apex portion of each of the protrusions may have a hexagonal pyramid shape. With this method, the apex portion of each of the protrusions has a hexagonal pyramid shape, so light is reflected by surfaces forming a hexagonal pyramid.

In the method, the arithmetic mean roughness of the rear surface may be not less than 0.5 µm and not more than 10 µm. With this method, an excessively small surface roughness contributes little to extraction efficiency by light diffuse reflection. An excessively large surface roughness contributes little to extraction efficiency by light diffuse reflection.

In the method, the active layer may be provided so as to have a peak wavelength in a wavelength range of not less than 350 nm and not more than 650 nm. With this method, excellent light extraction efficiency can be achieved with respect to light in the above-described wavelength range.

In the method, the active layer may be provided so as to have a peak wavelength in a wavelength range of not less than 450 nm and not more than 650 nm. With this method, excellent light extraction efficiency can be achieved with respect to light in the above-described wavelength range.

In the method, the semiconductor laminate may have a partially exposed region in one of the p-type gallium nitride-based semiconductor region and the n-type gallium nitride-based semiconductor region. The method may further include a step of forming a first electrode on the exposed region and forming a second electrode on the other one of the p-type gallium nitride-based semiconductor region and the n-type gallium nitride-based semiconductor region in the semiconductor laminate. Alternatively, the method may further include the steps of forming a first electrode on the processed surface of the substrate, and forming a second electrode on the semiconductor laminate. With this method, one electrical connection can be made through the second electrode, and the other electrical connection can be made through the electrode on the processed surface.

The method may further include the steps of growing one p-type gallium nitride-based semiconductor layer or a plurality of p-type gallium nitride-based semiconductor layers, one n-type gallium nitride-based semiconductor layer or a plurality of n-type gallium nitride-based semiconductor layers, and an active layer on the principal surface of the gallium nitride semiconductor wafer to form an epitaxial wafer, and etching the epitaxial wafer to form a semiconductor laminate. The p-type gallium nitride-based semiconductor layers, the n-type gallium nitride-based semiconductor layers, and the active layer may be arranged on the principal surface of the gallium nitride semiconductor wafer in the direction of a predetermined axis. The principal surface of the gallium nitride semiconductor wafer may be inclined at an angle in a range of not less than 10° and not more than 80° with respect to a <0001>-axis of the hexagonal gallium nitride semiconductor.

With this method, the principal surface of the gallium nitride semiconductor wafer has so-called semi-polarity. A plurality of gallium nitride-based semiconductors grown on the semi-polar surface are arranged in the direction of the predetermined axis.

In the method, the maximum value of the distance between two points on the edge of the wafer may be not less than 45 mm. This method can be applied to a wafer with a large diameter.

Yet another aspect of the invention provides a light emitting apparatus. The light emitting apparatus includes the above-described nitride-based semiconductor light emitting device, a support base having a support surface supporting the rear surface of the nitride-based semiconductor light emitting device, and a resin provided on the nitride-based semiconductor light emitting device and the support base to seal the nitride-based semiconductor light emitting device. Light from the nitride-based semiconductor light emitting device transmits the resin. With this light emitting apparatus, overhead luminance can be increased.

In the light emitting apparatus, the surface of the resin has a first portion which is in contact with the support base, and second portion which is exposed without being in contact with the support base. With this light emitting apparatus, the first portion is in contact with the support base, and the second portion is exposed without being in contact with the support base. For this reason, the resin includes no reflector other than the support base.

The foregoing objects and other objects, features, and advantages of the invention are apparent from the following detailed description of a preferred embodiment of the invention taken in conjunction with the accompanying drawings.

### Advantageous Effects of Invention

As described above, an aspect of the invention provides a nitride-based semiconductor light emitting device with excellent light extraction efficiency. Another aspect of the invention provides a method of manufacturing a nitride-based semiconductor light emitting device. Yet another aspect of the invention provides a light emitting apparatus including a nitride-based semiconductor light emitting device.

### Brief Description of Drawings

Fig. 1 is a drawing schematically showing a nitride-based semiconductor light emitting device according to this embodiment.
Fig. 2 is a drawing showing main steps in a method of manufacturing a nitride-based semiconductor light emitting device according to this embodiment.
Fig. 3 is a drawing showing main steps in a method of manufacturing a nitride-based semiconductor light emitting device according to this embodiment.
Fig. 4 is a drawing showing main steps in a method of manufacturing a nitride-based semiconductor light emitting device according to this embodiment.
Fig. 5 is a drawing showing connection for measurement of EL characteristics.
Fig. 6 is a drawing showing EL characteristics of an LED structure manufactured using an off-axis GaN wafer and EL characteristics of an LED structure manufactured using a c-plane GaN wafer.
Fig. 7 is a drawing showing an SEM image of a rear surface (alkali-etched) of an off-axis GaN substrate.
Fig. 8 is a drawing showing an SEM image of a rear surface of a GaN substrate when alkali etching is performed on a GaN substrate having a principal surface inclined at an angle of 75° from a c+-axis in an m-axis direction to roughen a rear surface of the GaN substrate.
Fig. 9 is a drawing showing an SEM image of a rear surface of a GaN substrate when alkali etching is performed on a GaN substrate having a principal surface inclined at an angle of 58° from a c+-axis in an a-axis direction to roughen the rear surface of the GaN substrate.
Fig. 10 is a drawing showing an SEM image of a rear surface of a GaN substrate when alkali etching is performed on a GaN substrate having a principal surface inclined at an angle of 68° from a c+-axis in a direction rotated at a certain angle from an a-axis direction to an m-axis direction to roughen the rear surface of the GaN substrate.
Fig. 11 is a drawing showing an SEM image of a rear surface (alkali-etched) of an m-plane GaN substrate.
Fig. 12 is a drawing showing an SEM image of a rear surface (alkali-etched) of a c-plane GaN substrate.
Fig. 13 is a drawing showing another structure of the nitride-based semiconductor light emitting device according to this embodiment.
Fig. 14 is a drawing showing yet another structure of the nitride-based semiconductor light emitting device according to this embodiment.
Fig. 15 is a drawing showing a relationship between an angle between the normal line to a principal surface of a GaN substrate and a c-axis and an Indium composition ratio in InGaN growth under identical growth conditions.
Fig. 16 is a drawing schematically showing an electrode forming step and a surface roughening step.
Fig. 17 is a drawing showing an LED structure in which an anode electrode and a cathode electrode are formed on an epitaxial surface and an LED structure in which an anode electrode is formed on an epitaxial surface and a cathode electrode is formed in a portion of a rear surface.
Fig. 18 is a drawing showing the configuration of a light emitting apparatus including the nitride-based semiconductor light emitting device according to this embodiment.

### Description of Embodiments

The finding of the invention can be easily understood taking into consideration the following detailed description taken in conjunction with the accompanying drawings for illustrating. An embodiment of a nitride-based semiconductor light emitting device and a method of manufacturing a nitride-based semiconductor light emitting device of the invention will be described with reference to the accompanying drawings. If possible, the same parts are represented by the same reference numerals. In the following description, a reverse crystal axis with respect to a <0001>-axis is represented by <000-1>.

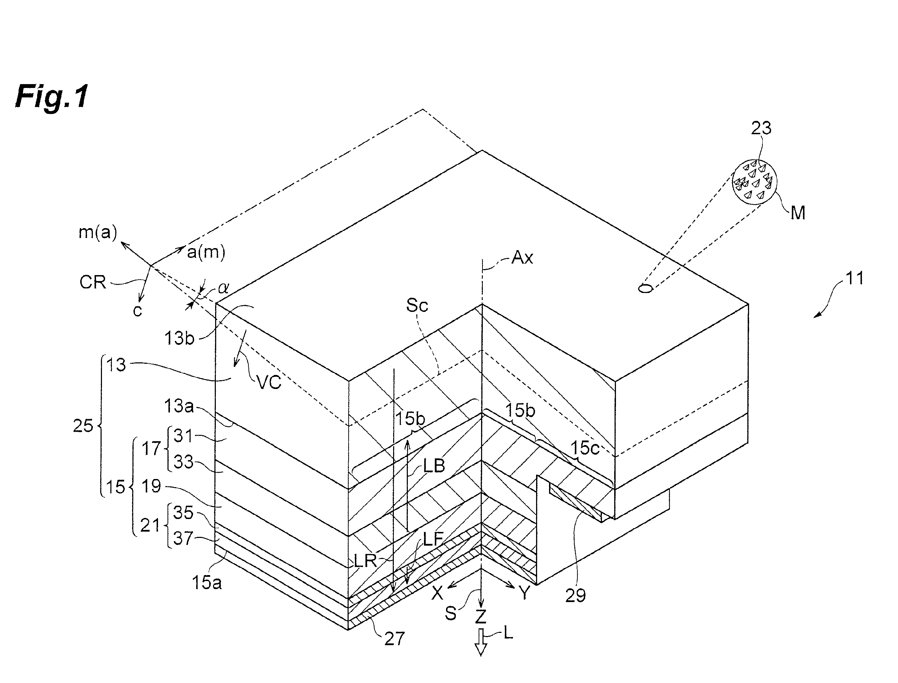

Fig. 1 is a drawing schematically showing a nitride-based semiconductor light emitting device according to this embodiment. A nitride-based semiconductor light emitting device 11 includes a support base 13 and a semiconductor laminate 15. The support base 13 includes a hexagonal gallium nitride semiconductor, and has a principal surface 13a and a rear surface 13b. The semiconductor laminate 15 includes an n-type gallium nitride-based semiconductor region 17, an active layer 19, and a p-type gallium nitride-based semiconductor region 21. The active layer 19 is provided between the p-type gallium nitride-based semiconductor region 21 and the n-type gallium nitride-based semiconductor region 17. The n-type gallium nitride-based semiconductor region 17, the active layer 19, and the p-type gallium nitride-based semiconductor region 21 are mounted on the principal surface 13a of the support base 13, and are arranged in the direction of a predetermined axis Ax orthogonal to the principal surface 13a. The rear surface 13b of the support base 13 is inclined with respect to a plane orthogonal to a reference axis extending in the c-axis direction of the hexagonal gallium nitride semiconductor. In Fig. 1, the c-axis direction is represented by a vector VC. A surface morphology M of the rear surface 13b has a plurality of protrusions 23 protruding in the direction of a <000-1>-axis. The direction of the predetermined axis Ax is different from the direction of the reference axis (the direction of the vector VC).

With this nitride-based semiconductor light emitting device 11, the p-type gallium nitride-based semiconductor region 21, the n-type gallium nitride-based semiconductor region 17, and the active layer 19 are arranged on the principal surface 13a of the support base 13 in the direction of the predetermined axis Ax. The rear surface 13b of the support base 13 is inclined with respect to the plane orthogonal to the reference axis represented by the vector VC. The direction of the predetermined axis Ax is different from the direction of the vector VC. For this reason, a light component LB which goes from the active layer 19 toward the substrate 13 is diffusely reflected by the rear surface 13b, such that the travelling direction thereof is changed. A reflected light component LR is provided from an emitting surface together with a light component LF which goes from the active layer 19 directly toward the emitting surface. In Fig. 1, outgoing light L is shown. The surface morphology M of the rear surface 13b has a plurality of protrusions 23 protruding reversely to the vector VC, so the rear surface 13b exhibits excellent diffuse reflectance. Therefore, the nitride-based semiconductor light emitting device 11 has excellent light extraction efficiency.

The nitride-based semiconductor light emitting device 11 is a surface emission-type device, and is configured such that the light components LB and LF from the active layer 19 are emitted from an upper surface 15a of the semiconductor laminate 15. Improvement in diffuse reflection performance of the rear surface 13b results in improvement in light extraction efficiency from the upper surface 15a. The light components LB and LF from the active layer 19 can be emitted from the rear surface 13b of the substrate. Improvement in diffuse reflection performance of the rear surface 13b results in improvement in light extraction efficiency from the rear surface 13b of the substrate.

In the nitride-based semiconductor light emitting device 11, the rear surface 13b of the substrate 13 can be inclined at an angle α in a range of not less than 10° and not more than 80° with respect to the <000-1>-axis of the hexagonal gallium nitride semiconductor. The inclination angle defines the inclination direction of the protrusions 23. For this reason, the rear surface 13b of the substrate has diffuse reflection performance higher than a mirror-polished rear surface. The principal surface 13a of the substrate 13 is inclined at an angle in a range of not less than 10° and not more than 80° with respect to the <0001>-axis of the hexagonal gallium nitride semiconductor. The active layer 19 is formed on the principal surface 13a of the substrate having semi-polarity, so there is little influence of a piezoelectric field on the active layer 19, as compared with an active layer on the c-plane. An angle between the predetermined axis Ax and the vector VC is not less than 10° and not more than 80°.

The above-described angle will be described. In the nitride-based semiconductor light emitting device 11, the principal surface 13a of the substrate 13 is inclined at an angle in a range of not less than 10° and not more than 80° with respect to the <0001>-axis of the hexagonal gallium nitride semiconductor and at an angle in a range of not less than 10° and not more than 80° with respect to the <000-1>-axis of the hexagonal gallium nitride semiconductor. The rear surface 13b of the substrate 13 is inclined at an angle in a range of not less than 10° and not more than 80° with respect to the <000-1>-axis of the hexagonal gallium nitride semiconductor and at an angle in a range of not less than 10° and not more than 80° with respect to the <0001>-axis of the hexagonal gallium nitride semiconductor. With this nitride-based semiconductor light emitting device 11, the inclination direction of the protrusions is defined in accordance with the above-described inclination angle.

In the nitride-based semiconductor light emitting device 11, the principal surface 13a of the substrate 13 may be inclined at an angle in a range of not less than 10° and not more than 80° with respect to the <0001>-axis of the hexagonal gallium nitride semiconductor, and the rear surface 13b of the substrate 13 may be inclined at an angle in a range of not less than 10° and not more than 80° with respect to the <000-1>-axis of the hexagonal gallium nitride semiconductor. With this nitride-based semiconductor light emitting device 11, the inclination direction of the protrusions is defined in accordance with the above-described inclination angle.

In the nitride-based semiconductor light emitting device 11, the principal surface 13a of the substrate 13 may be inclined at an angle in a range of not less than 55° and not more than 80° with respect to the <0001>-axis of the hexagonal gallium nitride semiconductor, and the rear surface 13b of the substrate 13 may be inclined at an angle in a range of not less than 55° and not more than 80° with respect to the <000-1>-axis of the hexagonal gallium nitride semiconductor. With this nitride-based semiconductor light emitting device 11, the inclination direction of the protrusions is defined in accordance with the above-described inclination angle.

In the nitride-based semiconductor light emitting device 11, the principal surface 13a of the substrate 13 may be inclined at an angle in a range of not less than 10° and not more than 80° with respect to the <000-1>-axis of the hexagonal gallium nitride semiconductor, and the rear surface 13b of the substrate 13 may be inclined at an angle in a range of not less than 10° and not more than 80° with respect to the <0001>-axis of the hexagonal gallium nitride semiconductor. With this nitride-based semiconductor light emitting device 11, the inclination direction of the protrusions is defined in accordance with the above-described inclination angle.

In the nitride-based semiconductor light emitting device 11, the principal surface 13a of the substrate 13 may be inclined at an angle in a range of not less than 55° and not more than 80° with respect to the <000-1>-axis of the hexagonal gallium nitride semiconductor, and the rear surface 13b of the substrate 13 may be inclined at an angle in a range of not less than 55° and not more than 80° with respect to the <0001>-axis of the hexagonal gallium nitride semiconductor. With this nitride-based semiconductor light emitting device 11, the inclination direction of the protrusions is defined in accordance with the above-described inclination angle.

With detailed observation in the experiment by the inventors, an apex portion of each of the protrusions 23 has a hexagonal pyramid shape. The apex portion of each of the protrusions 23 has a hexagonal pyramid shape, so light is reflected by surfaces forming a hexagonal pyramid.

The arithmetic mean roughness of the rear surface 13b may be not less than 1 µm. An excessively small surface roughness contributes little to extraction efficiency by light diffuse reflection. The arithmetic mean roughness of the rear surface 13b may be not more than 10 µm. An excessively large surface roughness contributes little to extraction efficiency by light reflection.

In Fig. 1, a c-plane Sc is shown as a representative. The hexagonal crystal axis is represented by a crystal coordinate system CR. The direction of the c-axis in the crystal coordinate system CR represents the direction of the c-plane. An a-axis or an m-axis is directed in a direction orthogonal to the c-axis. In Fig. 1, in order to show the structure of the nitride-based semiconductor light emitting device 11, an orthogonal coordinate system S is shown. The n-type gallium nitride-based semiconductor region 17, the active layer 19, and the p-type gallium nitride-based semiconductor region 21 are arranged on the principal surface 13a of the support base 13 in the Z-axis direction. The principal surface 13a and the rear surface 13b of the substrate 13 extend substantially in parallel to a plane defined by the X-axis and the Y-axis. In the preferred embodiment, the principal surface 13a is formed in parallel to the rear surface 13b.

A semiconductor structure 25 having the support base 13 and the semiconductor laminate 15 is provided with first and second electrodes 27 and 29. The electrodes 27 and 29 are an anode and a cathode. The semiconductor laminate 15 of the nitride-based semiconductor light emitting device 11 includes a mesa region 15b and an exposed region 15c. In the exposed region 15c, a portion of one of the p-type gallium nitride-based semiconductor region 21 and the n-type gallium nitride-based semiconductor region 17 is exposed. The second electrode 29 is provided on the exposed region 15c, and the first electrode 27 is provided on the other one of the p-type gallium nitride-based semiconductor region 21 and the n-type gallium nitride-based semiconductor region 17 in the semiconductor laminate 15. In this embodiment, the n-type gallium nitride-based semiconductor region 17, the active layer 19, and the p-type gallium nitride-based semiconductor region 21 are mounted on the support base 13 in that order, so the second electrode 29 is connected to the n-type gallium nitride-based semiconductor region 17, and the first electrode 27 is connected to the p-type gallium nitride-based semiconductor region 21. According to the nitride-based semiconductor light emitting device 11, in the case of p-down mounting, the entire surface of the semiconductor region is exposed with respect to a light extraction direction, light is not blocked by a pad electrode, and satisfactory light extraction efficiency can be provided. In this embodiment, no wire bonding is carried out, so reduction in mounting cost and improvement in yield are achieved.

The active layer 19 may have, for example, a bulk structure, a single quantum well structure, or a multiple quantum well structure. The active layer 19 may be provided so as to have a peak wavelength in a wavelength range of not less than 350 nm and not more than 650 nm. The rear surface 13b of the substrate 13 may diffusely reflect light in the above-described wavelength range. The active layer 19 may include GaN, InGaN, InAlGaN, or the like. When the active layer 19 has a quantum well structure, the active layer 19 has a well layer and a barrier layer. The active layer 19 may be provided so as to have a peak wavelength in a wavelength range of not less than 450 nm and not more than 650 nm. With regard to light in the above-described wavelength range, excellent light extraction efficiency can be achieved.

The n-type gallium nitride-based semiconductor region 17 includes one gallium nitride-based semiconductor layer or a plurality of gallium nitride-based semiconductor layers (in this embodiment, gallium nitride-based semiconductor layers 31 and 33). The gallium nitride-based semiconductor layer 31 may include, for example, n-type GaN or n-type AlGaN, AIN, or the like, and provides n-type carriers (electrons) and acts as a contact layer with respect to the cathode. The gallium nitride-based semiconductor layer 33 may be include, for example, n-type InGaN, InAlGaN, or the like, and acts as a buffer layer for the active layer.

The p-type gallium nitride-based semiconductor region 21 includes one gallium nitride-based semiconductor layer or a plurality of gallium nitride-based semiconductor layers (in this embodiment, gallium nitride-based semiconductor layers 35 and 37). The gallium nitride-based semiconductor layer 35 may include, for example, p-type AlGaN, InAlGaN, or the like, and provides a barrier with respect to the n-type carriers (electrons). The gallium nitride-based semiconductor layer 37 may include, for example, p-type AlGaN or p-type GaN, InGaN, or the like, and provides p-type carriers (holes) and acts as a contact layer with respect to the anode.

The substrate 13 may have conductivity. If necessary, in the nitride-based semiconductor light emitting device 11, first electrode 27 may be provided on the semiconductor laminate 15, and the second electrode 29 may be provided on the rear surface 13b of the substrate 13. With this structure, the mesa region 15b and the exposed region 15c are not required. Electrical connection to the p-type gallium nitride-based semiconductor region 21 may be made through the first electrode 27 on the semiconductor laminate 15, and electrical connection to the n-type gallium nitride-based semiconductor region 17 may be made through the second electrode 29 on the rear surface 13b of the substrate 13.

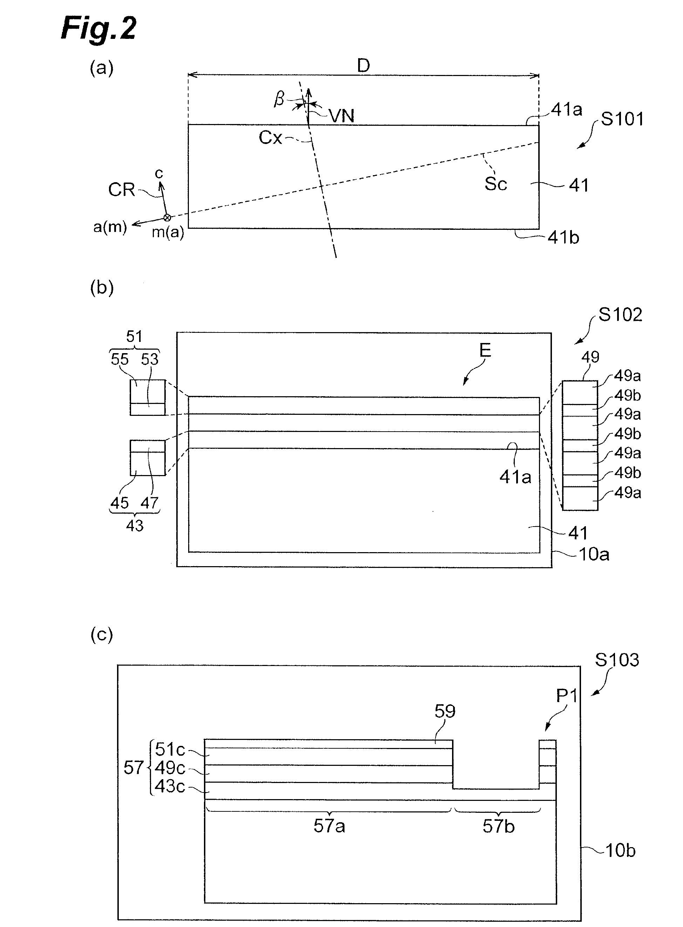

Figs. 2, 3, and 4 are drawings showing main steps in a method of manufacturing a nitride-based semiconductor light emitting device according to this embodiment.

As shown in Part (a) of Fig. 2, in Step S101, a gallium nitride semiconductor wafer (hereinafter, referred to as "GaN wafer") 41 including a hexagonal gallium nitride semiconductor is prepared. The gallium nitride semiconductor wafer 41 has a principal surface 41a and a rear surface 41b. The principal surface 41a of the GaN wafer 41 is inclined at an angle β in a range of not less than 10° and not more than 80° with respect to the <0001>-axis of the hexagonal gallium nitride semiconductor. The principal surface 41a of the GaN wafer 41 has so-called semi-polarity. Referring to Part (a) of Fig. 2, a representative c-plane Sc, a reference axis C_{X} extending in the c-axis direction, and a normal vector VN of the principal surface 41 a are shown. The c-plane Sc is orthogonal to the reference axis C_{X}. The reference axis C_{X} is inclined at an angle β with respect to the normal vector VN. The maximum value of the distance between two points on the edge of the wafer 41 may be, for example, not less than 45 mm. This can be applied to a wafer with a large diameter. As has already been described, the principal surface 41a of the substrate wafer 41 is inclined at an angle in a range of not less than 10° and not more than 80° with respect to the <0001>-axis of the hexagonal gallium nitride semiconductor and/or at an angle in a range of not less than 10° and not more than 80° with respect to the <000-1>-axis of the hexagonal gallium nitride semiconductor. The rear surface 41 b of the substrate wafer 41 is inclined at an angle in a range of not less than 10° and not more than 80° with respect to the <000-1>-axis of the hexagonal gallium nitride semiconductor and at an angle in a range of not less than 10° and not more than 80° with respect to the <0001>-axis of the hexagonal gallium nitride semiconductor.

After the GaN wafer 41 is placed in a growth furnace 10a, as shown in Part (b) of Fig. 2, in Step S102, a plurality of epitaxial films are grown on the principal surface 41a of the GaN wafer 41 to form an epitaxial wafer E. This growth is carried out by, for example, an organometallic vapor phase epitaxy. After thermal cleaning is carried out, first, an n-type gallium nitride-based semiconductor region 43 is formed on the principal surface 41a. An n-type gallium nitride-based semiconductor layer 45 is grown on the principal surface 41a. An n-type gallium nitride-based semiconductor layer 47 is grown on the n-type gallium nitride-based semiconductor layer 45. The n-type gallium nitride-based semiconductor layer 45 includes, for example, GaN, AlGaN, AIN, or the like, and the n-type gallium nitride-based semiconductor layer 47 includes, for example, InGaN, GaN, AlGaN, or the like.

Next, an active layer 49 is formed on the n-type gallium nitride-based semiconductor layer 47. In order to form the active layer 49, a barrier layer 49a and a well layer 49b are alternately grown. The barrier layer 49a may include, for example, GaN, InGaN, InAlGaN, or the like, and the well layer 49b may include, for example, InGaN, InAlGaN, or the like. The active layer 49 may be provided so as to have a peak wavelength in a wavelength range of not less than 350 nm and not more than 650 nm. With regard to light in such a wavelength range, excellent light extraction efficiency can be achieved. The active layer 49 may also be provided so as to have a peak wavelength in a wavelength range of not less than 450 nm and not more than 650 nm. With regard to light in such a wavelength range, excellent light extraction efficiency can be achieved.

Thereafter, a p-type gallium nitride-based semiconductor region 51 is formed on the active layer 49. A p-type gallium nitride-based semiconductor layer 53 is grown on the barrier layer 49a of the active layer 49. A p-type gallium nitride-based semiconductor layer 55 is grown on the p-type gallium nitride-based semiconductor layer 53. The p-type gallium nitride-based semiconductor layer 53 includes, for example, AlGaN or the like, and the p-type gallium nitride-based semiconductor layer 55 includes, for example, AlGaN, GaN, or the like.

With such growth, the epitaxial wafer E is obtained. A plurality of gallium nitride-based semiconductor regions 43, 49, and 51 are grown on the semi-polar principal surface 41a, and are arranged in a direction perpendicular to the principal surface 41a.

After the epitaxial wafer E is pulled out from the reactor 10a, if necessary, in Step S103, as shown in Part (c) of Fig. 2, the epitaxial wafer E is etched to form a semiconductor laminate 57. After a patterned mask 59 is formed on the epitaxial wafer E, the epitaxial wafer E is disposed in an etching system 10b. Dry etching (for example, reactive ion etching) is carried out by using the etching system 10b to form a substrate product P1. The substrate product P1 includes the semiconductor laminate 57 in which a mesa portion 57a and an exposed region 57b are formed in the epitaxial wafer E. In the mesa portion 57a, an n-type gallium nitride-based semiconductor layer 43c, an active layer 49c, and a p-type gallium nitride-based semiconductor layer 51c are arranged in a direction perpendicular to the principal surface 41a of the GaN wafer 41. After the substrate product P1 is pulled out from the system 10b, the mask 59 is removed.

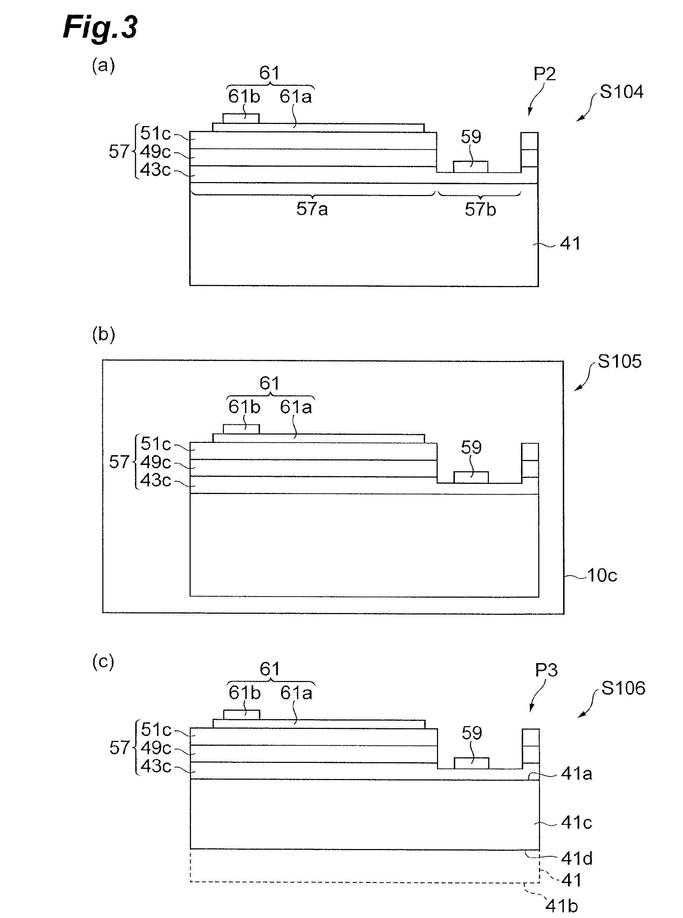

As shown in Part (a) of Fig. 3, the semiconductor laminate 57 has the partially exposed region 57b in one (in this embodiment, the n-type region 43c) of the gallium nitride-based semiconductor regions 5 1 c and 43c. In Step S104, a first electrode 59 is formed on the exposed region 57b, and a second electrode 61 is formed on the other one (in this embodiment, the p-type region 51c) of the gallium nitride-based semiconductor regions 51c and 43c of the semiconductor laminate 57. The electrode 61 includes a transparent 61a formed on the surface of the semiconductor laminate 57, and a pad electrode 61b formed on a portion of the transparent electrode 61a. Deposition of a metal film for an electrode is carried out by using a deposition system which performs sputtering or vapor deposition. Through these steps, a substrate product P2 is obtained.

After the electrodes are formed, as shown in Part (b) of Fig. 3, in Step S105, the electrodes of the substrate product P2 are annealed by using an annealing system 10c.

After the electrodes are annealed, as shown in Part (c) of Fig. 3, in Step S106, with the method according to the invention, the rear surface 41b of the GaN wafer 41 is grinded to form a grinded GaN wafer 41d. In the following description, the grinded GaN wafer 41d is referred to as "substrate 41c". The substrate 41c has a principal surface 41 a and a rear surface 41 d. With this step, a substrate 41 d for a substrate product P3 is formed. The substrate product P3 includes the substrate 41c and the semiconductor laminate 57 provided on the principal surface 41a. A substrate having a desired thickness can be obtained by grinding. Grinding is carried out such that the rear surface 41d of the substrate 41c is inclined with respect to a plane orthogonal to the reference axis C_{X} extending in the c-axis direction of the hexagonal gallium nitride semiconductor. The rear surface 41d is substantially parallel to the principal surface 41a. An arithmetic mean roughness Ra after grinding is not less than 0.1 µm and not more than 0.5 µm.

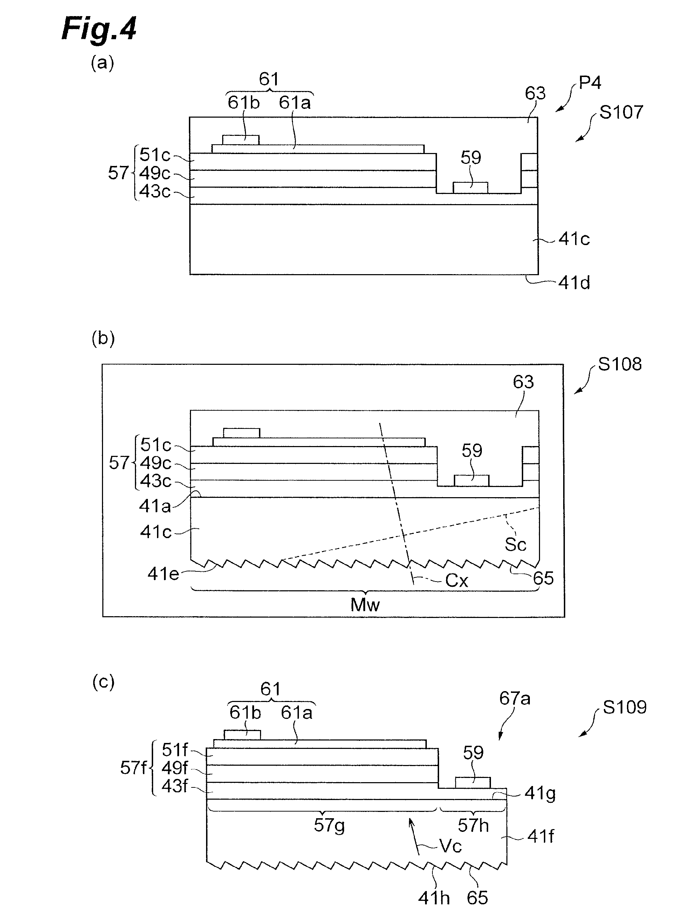

As shown in Part (a) of Fig. 4, for example, a protective film 63 is formed on the semiconductor laminate 57 of the substrate product P3. Thus, in Step S107, a substrate product P4 is prepared. The protective film 63 may be formed of, for example, a resist film or the like. The rear surface 41d of the substrate 41c of the substrate product P4 is exposed.

As shown in Part (a) of Fig. 4, the substrate product P4 is placed in the etching system 10d, the rear surface 41d of the substrate 41 c is etched to form a processed surface 41e. The processed surface 41e has a surface morphology M_{W} with a plurality of protrusions 65. Etching is performed on the grinded rear surface 41 d, thereby forming the processed surface 41e.

The p-type gallium nitride-based semiconductor region 51c, the n-type gallium nitride-based semiconductor region 43c, and the active layer 49c are mounted on the principal surface 41a of the substrate 41 c, and are arranged in an arrangement direction perpendicular to the principal surface 41a. The arrangement direction is different from the direction of the reference axis. The protrusions 65 protrude in the direction of the reference axis C_{X}.

With Step S108, etching is performed on the rear surface 41d of the substrate 41c, thereby forming the processed surface 41e in the substrate 41c. The processed surface 41e has a surface morphology M_{W} with a plurality of protrusions 65. The arrangement direction of the p-type gallium nitride-based semiconductor region 51c, the active layer 49c, and the n-type gallium nitride-based semiconductor region 43c is different from the direction of the reference axis C_{X}. The protrusions 65 protrude in a direction different from the arrangement direction. For this reason, a light component which goes from the active layer 49c toward the substrate 41c is diffusely reflected by the processed surface 41e, such that the travelling direction thereof is changed. The surface morphology M_{W} of the processed surface 41e has a plurality of protrusions 65 protruding in the direction of the reference axis C_{X}, so the processed surface 41e exhibits an excellent diffuse reflection characteristic. Therefore, a method of manufacturing a nitride-based semiconductor light emitting device with excellent light extraction efficiency is provided.

An apex portion of each of the protrusions 65 has a hexagonal pyramid shape, so light is reflected by surfaces forming a hexagonal pyramid. The arithmetic mean roughness of the processed surface 41e may be not less than 0.5 µm. An excessively small surface roughness contributes little to extraction efficiency by light reflection. The arithmetic mean roughness of the processed surface 41e may be not more than 10 µm. An excessively large surface roughness contributes little to extraction efficiency by light reflection.

The rear surface 41d of the substrate 41c is inclined at an angle in a range of not less than 10° and not more than 80° with respect to the <000-1>-axis of the hexagonal gallium nitride semiconductor, so the inclination direction of the protrusions is defined in accordance with the above-described inclination angle.

In forming the processed surface 41e, wet etching may be used so as to form a plurality of protrusions 65. The processed surface 41e may be formed by alkali solution. Examples of alkali solution include, for example, potassium hydroxide (KOH), sodium hydroxide (NaOH), or the like.

After the protective film 63 is removed, the substrate product is cut to produce a nitride-based semiconductor light emitting device 67a. The nitride-based semiconductor light emitting device 67a includes a support base 41f and a semiconductor laminate 57f. The support base 41f includes a hexagonal gallium nitride semiconductor, and has a principal surface 41g and a rear surface 41h. The semiconductor laminate 57f includes a mesa portion 57g and an exposed region 57h. The semiconductor laminate 57f includes an n-type gallium nitride-based semiconductor region 43f, an active layer 49f, and a p-type gallium nitride-based semiconductor region 51f. The active layer 49f is provided between the p-type gallium nitride-based semiconductor region 51f and the n-type gallium nitride-based semiconductor region 43f. The n-type gallium nitride-based semiconductor region 43f, the active layer 49f, and the p-type gallium nitride-based semiconductor region 51f are mounted on the principal surface 41g of the support base 41f, and are arranged in the direction of an axis orthogonal to the principal surface 41g. The rear surface 41h of the support base 41f is inclined with respect to a plane orthogonal to the reference axis C_{X} extending in the c-axis direction of the hexagonal gallium nitride semiconductor. In Part (c) of Fig. 4, the c-axis direction is represented by a vector VC. The surface morphology of the rear surface 41g has a plurality of protrusions 65 protruding in the direction of the <000-1>-axis.

The manufacturing method described with reference to Figs. 2 to 4 is just an example. For example, in the method according to this embodiment, after the processed surface of the wafer 41 is formed to form the substrate, the first electrode may be formed on the processed surface of the substrate, and the second electrode can be formed on the semiconductor laminate. Alternatively, after the second electrode is formed on the semiconductor laminate, the processed surface of the wafer 41 may be formed to form the substrate, and then the first substrate may be formed on the processed surface of the substrate. With these methods, one electrical connection can be made through the second electrode, and the other electrical connection can be made through the electrode on the processed surface.

### (Example)

A blue light emitting diode is prepared by an organometallic vapor phase epitaxy. As raw materials, trimethyl gallium (TMG), trimethyl aluminum (TMA), trimethyl indium (TMI), and ammonia (NH₃) are used, and as n-type and p-type dopants, silane (SiH₄) and biscyclopentadienyl magnesium (CP₂Mg) are used.

A c-plane gallium nitride wafer S1 of a size of 2 inches and a gallium nitride wafer S2 with an off-axis angle are prepared. The principal surface of the wafer S2 is inclined at 18° in the a-axis direction from the (0001) face (Ga face), and the rear surface of the wafer S2 is inclined at an angle of 18° from the (000-1) face (N face), similarly. The principal surfaces of the wafers S1 and S2 are subjected to mirror polishing.

The wafer S1 is placed in a reactor. Thermal treatment is performed in the reactor for 10 minutes while causing NH₃ and H₂ to flow in the reactor under the conditions of a substrate temperature of 1100°C and furnace pressure 27 kPa, and then the substrate temperature is changed to 1150°C, such that a Si-doped GaN layer is grown. The thickness of the GaN layer is, for example, 2 µm. The substrate temperature turns down to 850°C, and then TMG, TMI, and SiH₄ are supplied into the reactor, such that a Si-doped InGaN buffer layer is grown on the Si-doped GaN layer. The thickness of the InGaN buffer layer is 100 nm.

Thereafter, the substrate temperature turns up to 870°C, and then the GaN barrier layer is grown. The thickness of the GaN barrier layer is 15 nm. Next, the substrate temperature turns down to 800°C, such that an InGaN well layer is grown. The thickness of the InGaN well layer is 3 nm. In addition, the substrate temperature turns up to 870°C, and then the GaN barrier layer is grown. The thickness of the GaN barrier layer is 15 nm. The well layer and the barrier layer are repeatedly grown, such that a multiple quantum well structure at three periods of a well layer and a barrier layer is produced.

Thereafter, the supply of TMG and TMI into the reactor is stopped, and the substrate temperature turns up to 1100°C. At this temperature, TMG, TMA, NH₃, and CP₂Mg are supplied into the reactor, such that an Mg-doped p-type AlGaN layer is grown. The thickness of the p-type AlGaN layer is 20 nm. The substrate temperature is maintained, and the supply of TMA is stopped, such that a p-type GaN layer is grown. The thickness of the p-type GaN layer is 50 nm. After the layers are formed, the temperature turns down to room temperature, and the epitaxial wafer is pulled out from the reactor.

In addition, a GaN wafer S2 is used to produce an epitaxial wafer having a blue light emitting diode structure by an organometallic vapor phase epitaxy in the same manner as described above. With regard to the wafers S1 and S2, the conditions of the detailed temperature or the flow rate of raw materials are different.

The GaN wafers S1 and S2 are used to produce an epitaxial wafer having a light emitting diode structure, which emits light with a certain light emission wavelength.

Subsequently, electrodes are formed on the epitaxial wafer produced as described above. In this step, a mesa region and an exposed region having a thickness of 500 nm are formed by reactive ion etching (RIE). In the exposed region, a Si-doped GaN layer is exposed. A p-transparent electrode (Ni/Au) and a p-pad electrode (Au) are formed on the p-type GaN layer in the mesa region, and an n-electrode (Ti/Al) is formed in the exposed region. After the electrodes are formed, electrode annealing is performed to produce a substrate product. The temperature and time at the time of electrode annealing are 550°C and 1 minute. After the respective steps, photolithography, ultrasonic cleaning, and the like are performed.

Subsequently, the substrate product is divided into halves. Then, mirror polishing is performed on the rear surface of one wafer piece, and etching by alkali solution is performed on the other wafer piece. With this step, the processed substrate product is obtained. With etching, minute concavo-convexes of about 0.5 to 10 µm are formed at the rear surface of the substrate product. The chip size is 400 µm×400 µm.

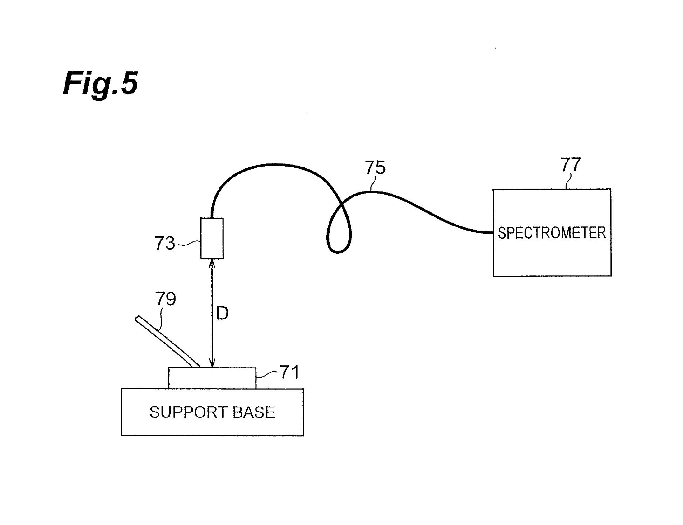

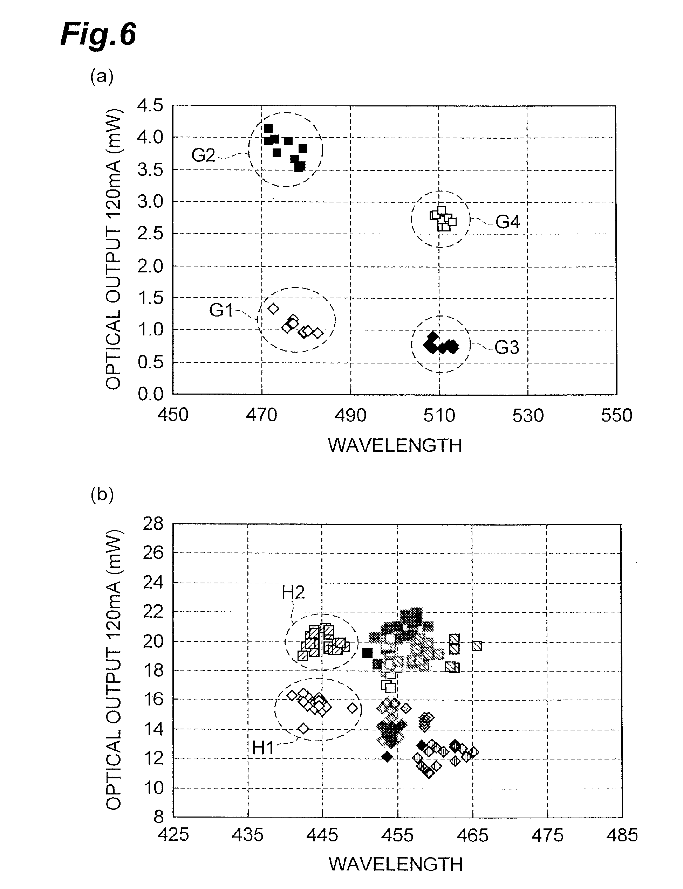

Applying a current to an LED chip of the substrate product manufactured as described above, current injection light emission (electroluminescence: EL) is evaluated. Fig. 5 shows connection for measurement of EL characteristics. A processed substrate product 71 for measurement of EL characteristics is placed on a support base. A lens unit 73 is arranged directly above the substrate product 71 at a distance D from the substrate product 71. The lens unit 73 is connected to a spectrometer 77 through an optical fiber 75. A power supply 79 is connected to the electrodes of the LED of the substrate product 71. A current of 120 mA is applied from the power supply 79 to the LED for measurement. Part (a) of Fig. 6 shows EL characteristics in an LED structure produced by using an off-axis GaN wafer. Part (b) of Fig. 6 shows EL characteristics in an LED structure produced by using a c-plane GaN wafer.

### Off-Axis GaN Substrate

Referring to Part (a) of Fig. 6, for a first group G1 of measurement points, the rear surface is subjected to mirror polishing, and light with a wavelength of about 480 nm is emitted. For a second group G2 of measurement points, the rear surface is subjected to etching, and light with a wavelength of about 480 nm is emitted. For a third group G3 of measurement points, the rear surface is subjected to mirror polishing, and light with a wavelength of about 510 nm is emitted. For a fourth group G4 of measurement points, the rear surface is subjected to etching, and light with a wavelength of about 510 nm is emitted.

With regard to light emission with wavelengths of 480 nm and 510 nm, the optical output of an LED having a rear surface subjected to etching is larger than that of an LED having a rear surface subjected to mirror polishing. Specifically, on an average over the LEDs with light emission wavelengths of 480 nm and 510 nm, the optical output of an LED having a rear surface subjected to etching is 3.70 times larger than that of an LED having a rear surface subjected to mirror polishing.

### c-plane GaN Substrate

Referring to Part (b) of Fig. 6, for a first group H1 of measurement points, the rear surface is subjected to mirror polishing, and light with a wavelength of about 445 nm is emitted. For a second group H₂ of measurement points, the rear surface is subjected to etching, and light with a wavelength of about 445 nm is emitted. With regard to the LEDs with a light emission wavelength of about 445 nm, the optical output of an LED having a rear surface subjected to etching is 1.39 times larger than that of an LED having a rear surface subjected to mirror polishing.

When the rear surface of the substrate is roughened by etching, the rate of improvement in the optical output of an LED using an off-axis GaN substrate is larger than that of the optical output of an LED using a c-plane GaN substrate.

With regard to the c-plane GaN substrate and the off-axis GaN substrate, when the rear surface is roughened by alkali etching so as to improve the light extraction efficiency of the LED, in particular, overhead luminance, the effect significantly differs. The effect is very large by the off-axis GaN substrate.

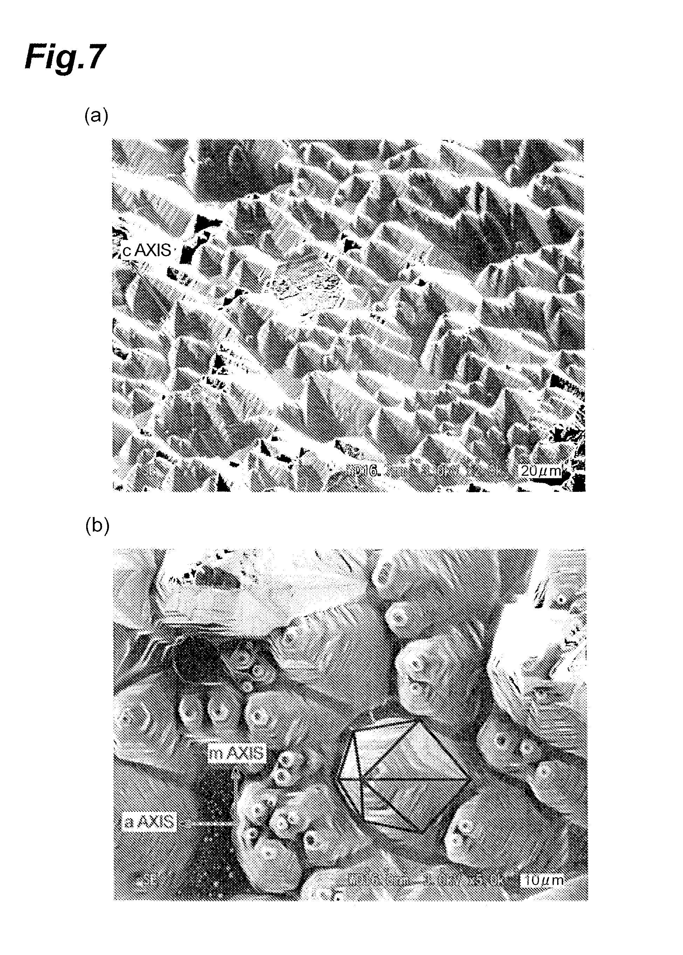

As described above, in order to find why the effect that the rear surface is roughened by alkali etching significantly differs between the c-plane GaN substrate and the off-axis GaN substrate, the state of the rear surface of the substrate after alkali etching is observed by using a scanning electron microscope (SEM). Fig. 7 shows an SEM image of the rear surface (alkali-etched) of the off-axis GaN substrate. Part (a) of Fig. 7 shows an SEM image in an oblique view, and Part (b) of Fig. 7 shows an SEM image from above.

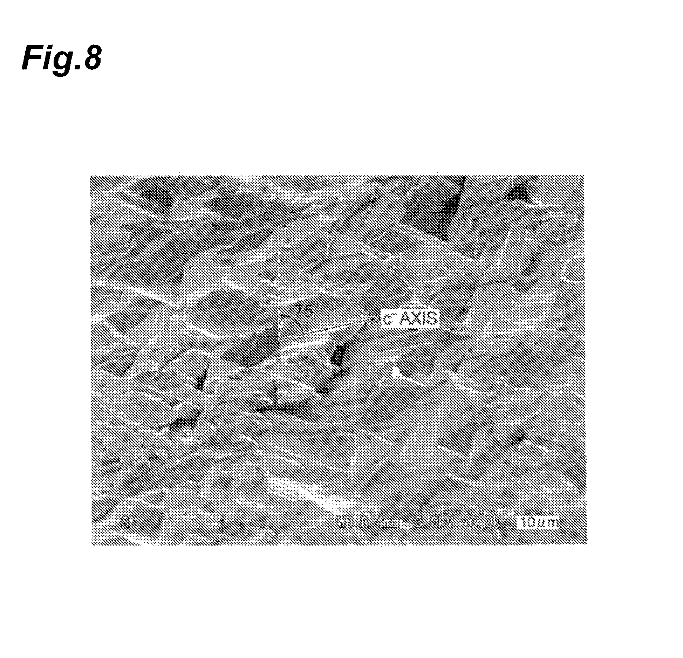

In addition, the SEM image of a rear surface of a GaN substrate having a certain off-axis angle is photographed. Fig. 8 shows an SEM image of a GaN surface when alkali etching is performed on a GaN substrate having a principal surface inclined at an angle of 75° from the c+-axis in the m-axis direction to roughen the rear surface. Referring to Fig. 8, when the rear surface is roughened, the protrusions are directed in a direction (the direction of the c-axis) substantially inclined at 75° with respect to the normal line axis of the rear surface. With regard to a GaN substrate having a comparatively large off-axis angle of 75°, when the rear surface is roughened, the protrusions are related to the off-axis direction and the off-axis angle of the c-axis.

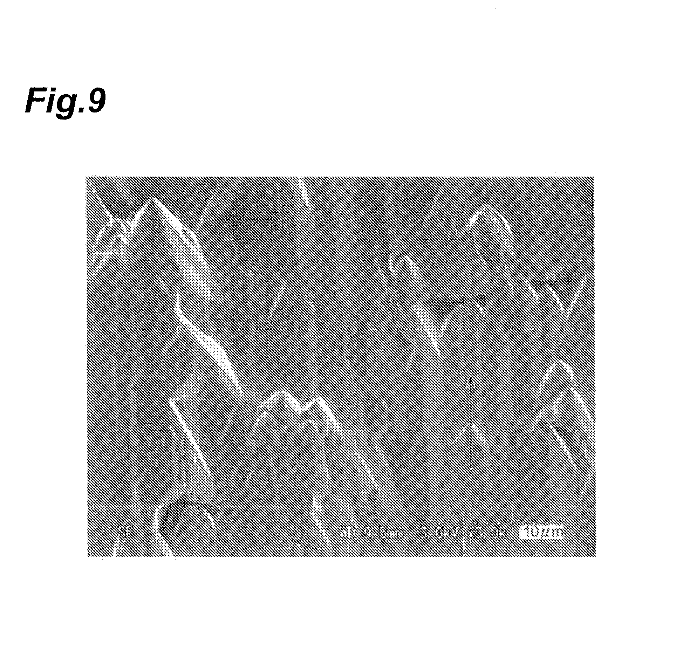

Fig. 9 shows an SEM image of a GaN surface when alkali etching is performed on a GaN substrate having a principal surface inclined at 58 from the c+-axis in the a-axis direction to roughen the rear surface. Referring to Fig. 9, when the rear surface is roughened, the protrusions are directed in a direction (the direction of the c-axis) inclined at an angle of about 58 with respect to the normal line axis of the rear surface. With regard to a GaN substrate having a comparatively large off-axis angle of 58°, when the rear surface is roughened, the protrusions are related to the off-axis direction and the off-axis angle of the c-axis.

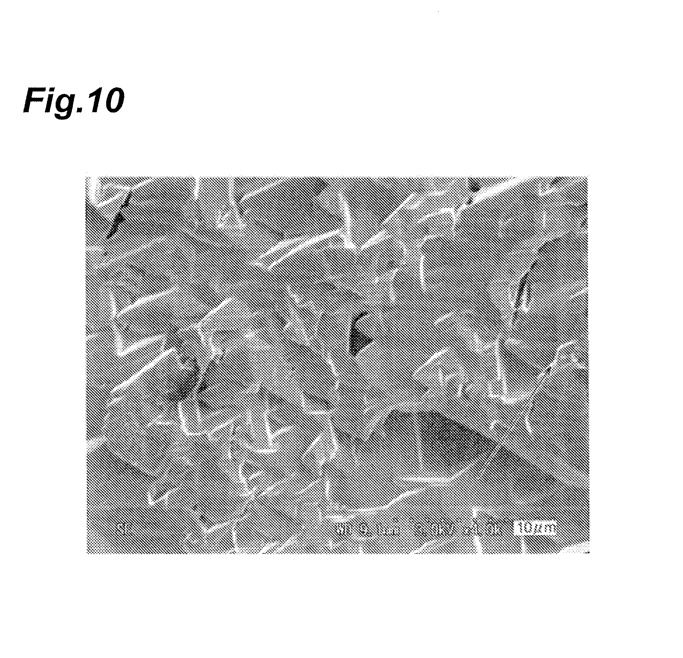

Fig. 10 shows an SEM image of a GaN surface when alkali etching is performed on a GaN substrate having a principal surface inclined at an angle of 68° from the c+-axis in a direction rotated at a certain angle (for example, 15°) from the a-axis direction to the m-axis direction to roughen the rear surface. Referring to Fig. 10, when the rear surface is roughened, the protrusions are directed in a direction (the direction of the c-axis) inclined at an angle of about 68° with respect to the normal line axis of the rear surface. With regard to a GaN substrate having a comparatively large off-axis angle of 68°, when the rear surface is roughened, the protrusions are related to the off-axis direction and the off-axis angle of the c-axis.

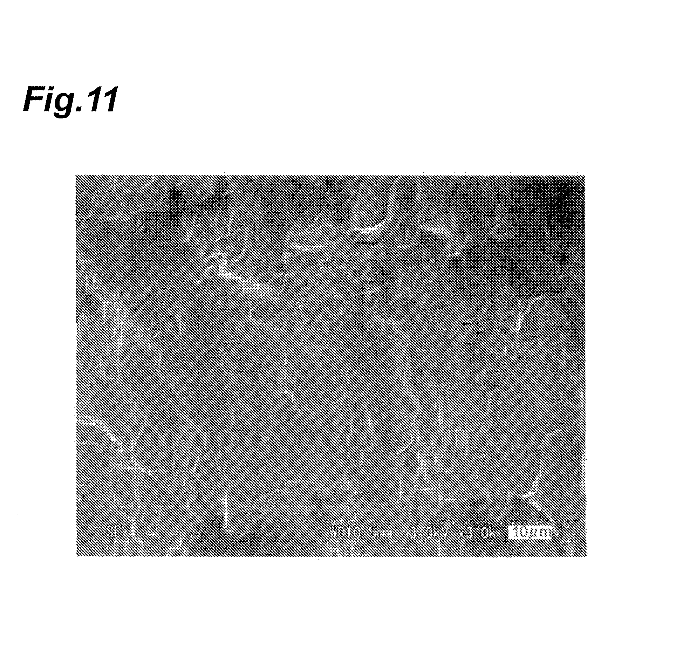

Fig. 11 shows an SEM image of a rear surface (alkali-etched) of an m-plane GaN substrate. The SEM image of Fig. 11 shows that, even if alkali etching is performed on the rear surface of the m-plane GaN substrate, a group of protrusions directed in the c-axis direction on the semi-polar surface is not formed.

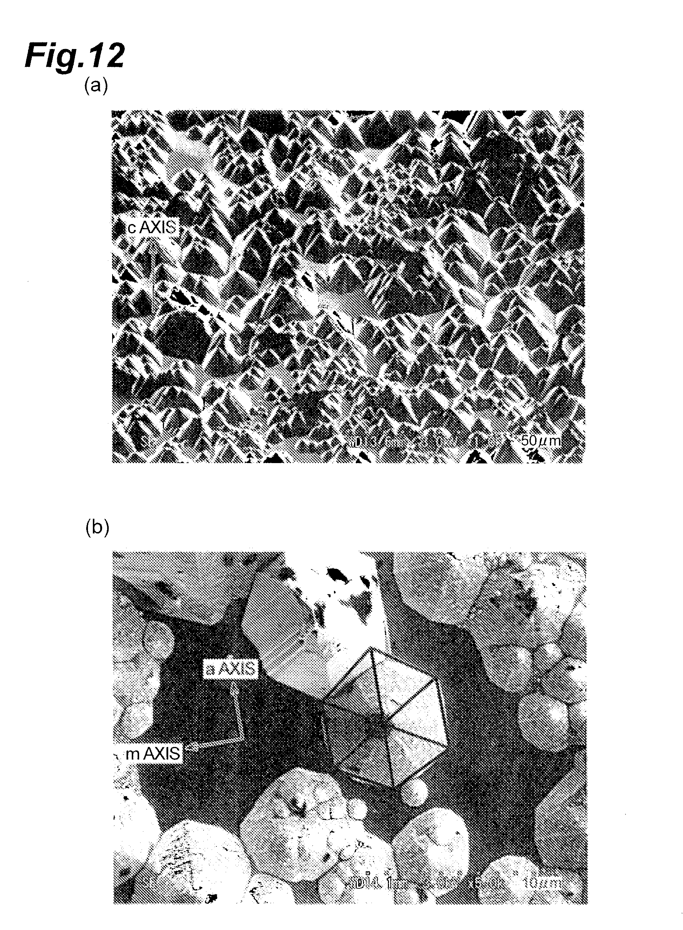

Fig. 12 shows an SEM image of a rear surface (alkali-etched) of a c-plane GaN substrate. Part (a) of Fig. 12 shows an SEM image in an oblique view, and Part (b) of Fig. 12 shows an SEM image from above.

While the c-plane GaN substrate is provided with multiple hexagonal protrusions extending in the c-axis direction by alkali etching, the off-axis GaN substrate is provided with hexagonal protrusions extending in a direction which substantially represents the gradient of the c-axis. That is, it is thought that the gradient of the protrusions results in a difference in overhead luminance of a light emitting diode when the rear surface is roughened.

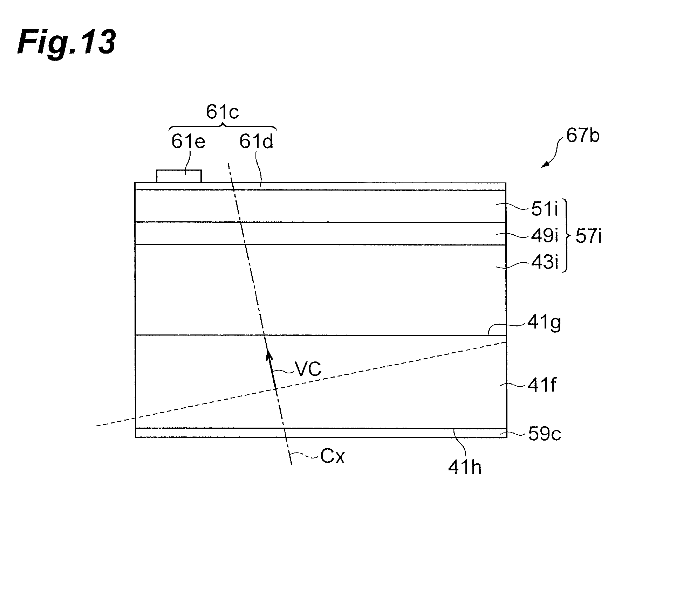

Fig. 13 is a diagram showing another structure of the nitride-based semiconductor light emitting device according to this embodiment. A nitride-based semiconductor light emitting device 67b includes a support base 41f and a semiconductor laminate 57i. The support base 41f includes a hexagonal gallium nitride semiconductor, and has a principal surface 41f and a rear surface 41h. The semiconductor laminate 57i includes an n-type gallium nitride-based semiconductor region 43i which is substantially identical to the n-type gallium nitride-based semiconductor region 43f, an active layer 49i which is substantially identical to the active layer 49f, and a p-type gallium nitride-based semiconductor region 51i which is substantially identical to the p-type gallium nitride-based semiconductor region 51f. The n-type gallium nitride-based semiconductor region 43i, the active layer 49i, and the p-type gallium nitride-based semiconductor region 51i are mounted on the entire principal surface 41g of the support base 41f and arranged in the direction of an axis orthogonal to the principal surface 41g. The rear surface 41h of the support base 41f extends along a plane orthogonal to the reference axis C_{X} which extends in the c-axis direction of the hexagonal gallium nitride semiconductor. In Fig. 13, the c-axis direction is represented by a vector VC. A surface morphology of the rear surface 41h has a plurality of protrusions (the same shape as the protrusions 65) protruding in the direction of the <000-1>-axis. An electrode 59c is formed on the rear surface 41h of the support base 41f, and an electrode 61c (transparent electrode 61d and pad electrode 61e) is formed on the upper surface of the semiconductor laminate 57i.

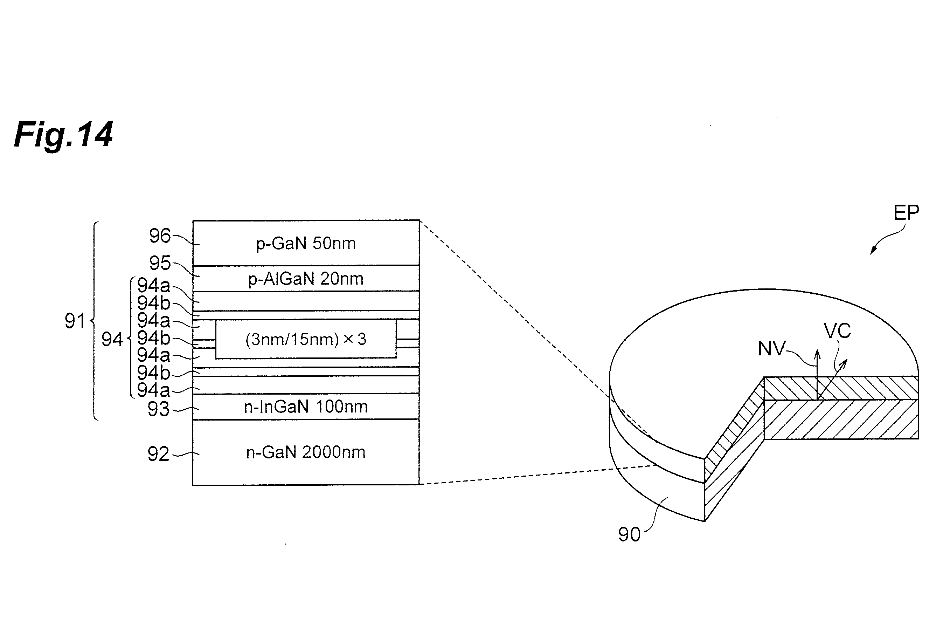

Fig. 14 is a diagram showing yet another structure of the nitride-based semiconductor light emitting device according to this embodiment. A GaN substrate 90 with a surface inclined at an off-axis angle (an angle between the normal vector NV and the c-axis vector VC) of 75° from the c-axis in the m-axis direction as a principal surface is prepared. An epitaxial structure layer 91 for a light-emitting diode is grown on the GaN substrate 90. The epitaxial structure layer 91 is produced by an organometallic vapor phase epitaxy. As raw materials, trimethyl gallium (TMG), trimethyl aluminum (TMA), trimethyl indium (TMI), ammonia (NH₃), silane (SiH₄), and biscyclopentadienyl magnesium (CP₂Mg) are used.

After the substrate is placed in a reactor, thermal treatment is performed on the GaN substrate for 10 minutes under the conditions of a temperature of 1050°C and furnace pressure of 27 kPa, while causing ammonia and hydrogen to flow in the reactor.

In a step of growing the n-type semiconductor layer, the substrate temperature is changed, and then a Si-doped GaN layer 92 is grown on the GaN substrate 90 at the substrate temperature of 950°C. The thickness of the GaN layer 92 is, for example, 2 µm. After the substrate temperature is changed, TMG, TMI, ammonia, and monosilane are supplied into the reactor at the substrate temperature of 850°C, such that a Si-doped InGaN layer 93 is grown on the GaN substrate 90. The thickness of the InGaN buffer layer 93 is, for example, 100 nm.

In a step of growing the active layer 94, the substrate temperature is changed, and then a GaN barrier layer 94a is grown at the substrate temperature of 870°C. The thickness of the barrier layer 94a is, for example, 15 nm. Next, the substrate temperature turns down to 720°C, and then an InGaN well layer 94b is grown. The thickness of the well layer 94b is 3 nm. Thereafter, growth of a GaN barrier layer (thickness 15 nm) 94a at the substrate temperature of 870°C and growth of a well layer (thickness 3 nm) 94b at the substrate temperature of 720°C are repeated, thereby growing a multiple quantum well structure at three periods.

In a step of growing the p-type semiconductor layer, the supply of TMG and TMI is stopped and the substrate temperature turns up to 900°C, and then, TMG, TMA, ammonia, and CP₂Mg are supplied into the reactor, such that an Mg-doped p-type AlGaN layer 95 is grown on the active layer 94. The thickness of the AlGaN layer 95 is, for example, 20 nm. After the supply of TMA is stopped, a p-type GaN layer 96 is grown on the AlGaN layer 95. The thickness of the GaN layer 96 is, for example, 50 nm. With these steps, epitaxial growth is completed. The temperature of an epitaxial substrate EP turns down to room temperature, and then the epitaxial substrate EP is pulled out.

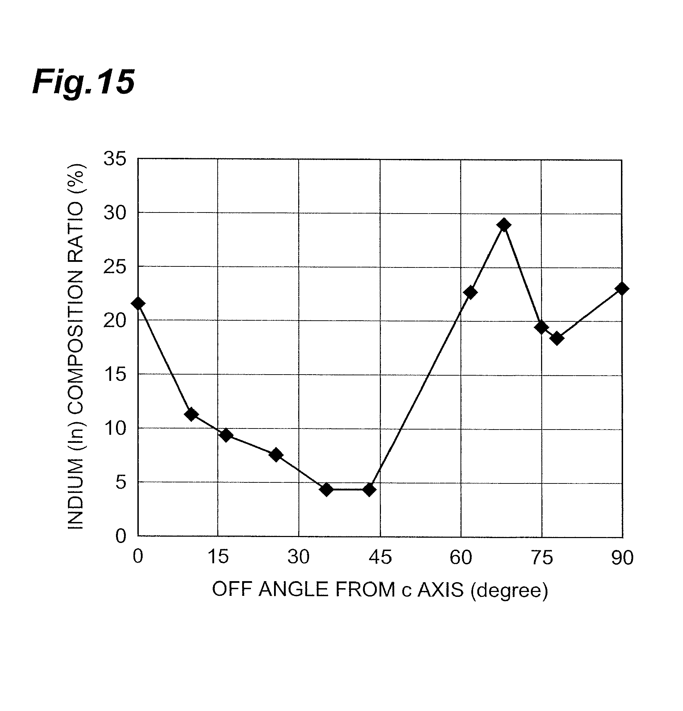

Fig. 15 is a diagram showing a relationship between an angle between the normal line to the principal surface of the GaN substrate and the c-axis and an Indium composition ratio in InGaN growth under the same conditions. In the angle range of not less than 55°, further, not less than 58° and not more than 80°, Indium uptake is satisfactory. When a light emitting diode with a long wavelength is produced, this characteristic results in improvement in the quality of the light emitting layer. In addition, in the light emitting diode, reflectance on the rear surface can be increased.

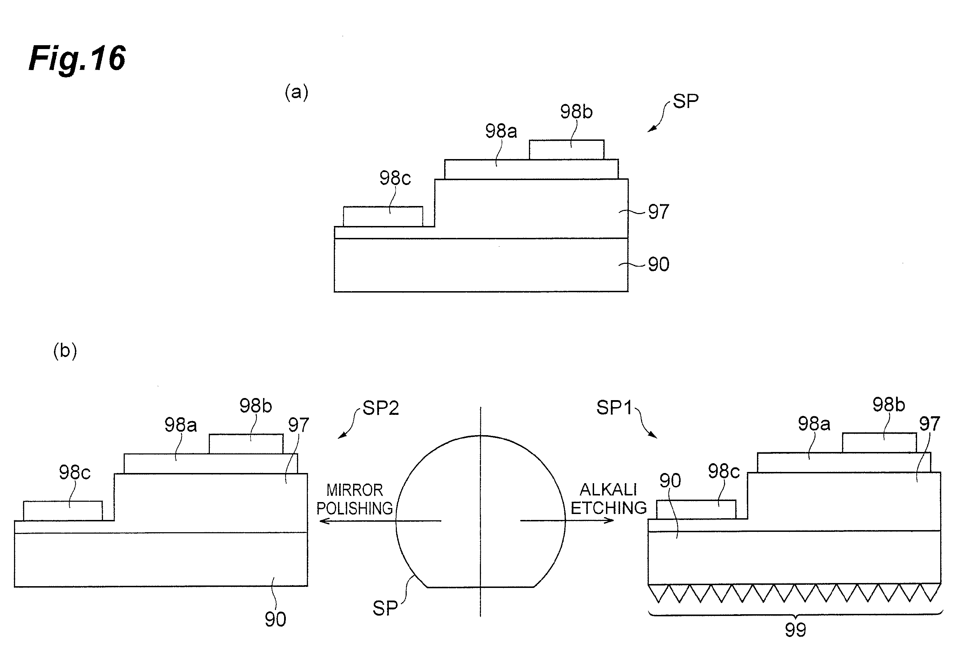

Fig. 16 is a diagram schematically showing an electrode forming step and a surface roughening step. Electrodes are formed on the epitaxial substrate EP. In this step, a mesa 97 is formed on the epitaxial substrate EP by a reactive ion etching (RIE). The height of the mesa is, for example, 500 nm. After the mesa is formed, a p-transparent electrode (Ni/Au) 98a, a p-pad electrode (Au) 98b, and an n-electrode (Ti/Al) are formed. After the electrodes are formed, electrode annealing (for 1 minute at 550°C) is performed. After the respective steps, photolithography, ultrasonic cleaning, and the like are used. With these steps, a substrate product SP shown in Part (a) of Fig. 16 is formed.

Subsequently, the substrate product SP is divided into halves to produce a substrate product SP1 and a substrate product SP2. After the entire surface of the substrate product SP1 is covered with resist, etching (for example, alkali etching) is performed on the substrate product SP1, a roughened surface 99 is formed at the rear surface of the substrate product SP1. After the entire surface of the substrate product SP2 is covered with resist, mirror polishing is performed on the rear surface of the substrate product SP2, such that a mirror surface is formed in half of the rear surface of the substrate product SP.

The measurement arrangement shown in Fig. 5 is carried out to examine a difference in rear surface reflection. Light from a light emitting diode is directed to a detector through an optical fiber. Light which is focused on the optical fiber is light which travels directly above the LED. As a result, in the case of an LED on a GaN substrate having a principal surface inclined at an angle of 75° in the m-axis direction, since the rear surface is roughened by alkali etching, the light emission output of the LED is 3.12 times larger than the light emission output of an LED whose rear surface is subjected to mirror polishing. This experiment result shows that, even in the case of a substrate having a high off-axis angle, the rear surface is roughened by alkali etching, such that the light extraction efficiency of the light emitting diode, in particular, overhead luminance is significantly improved.

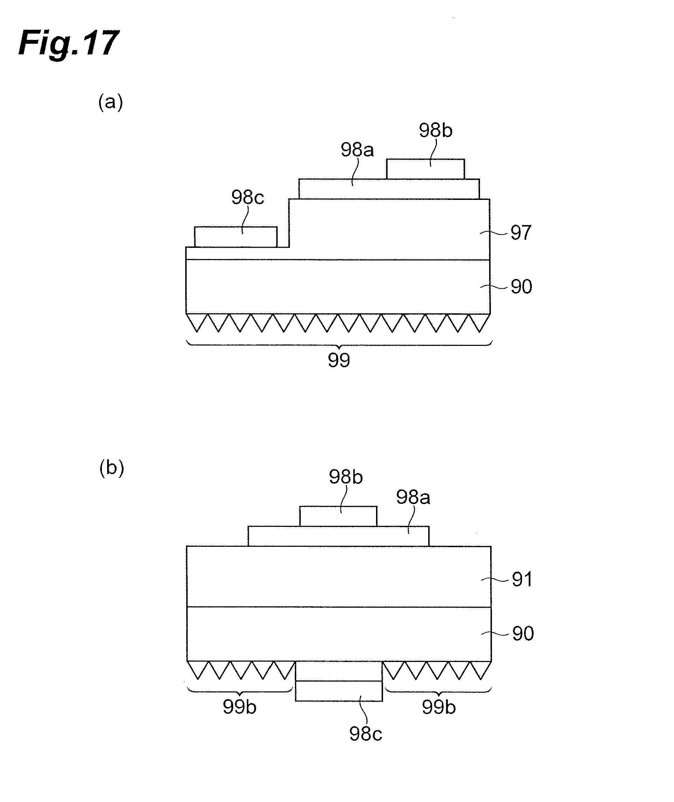

Part (a) of Fig. 17 shows an LED structure in which an anode electrode and a cathode electrode are formed on an epitaxial surface. In this LED structure, the entire rear surface can be used for reflection. Part (b) of Fig. 17 shows an LED structure in which an anode electrode is formed on an epitaxial surface and a cathode electrode is formed on a portion of a rear surface. In this LED structure, no mesa is formed. While the entire rear surface cannot be used for reflection, the light emission region of the active layer can be widened. In the LED structure, a portion of the rear surface is masked so as not to be etched, a roughened surface is partially formed, and an electrode 98c is formed in an area where no roughened surface is formed. With this structure, improvement in the rear surface reflection can be achieved by the roughened surface 99b, and two kinds of electrodes can be produced on the upper surface and lower surface of the epitaxial substrate. By using the GaN substrate, a current is sufficiently diffused.

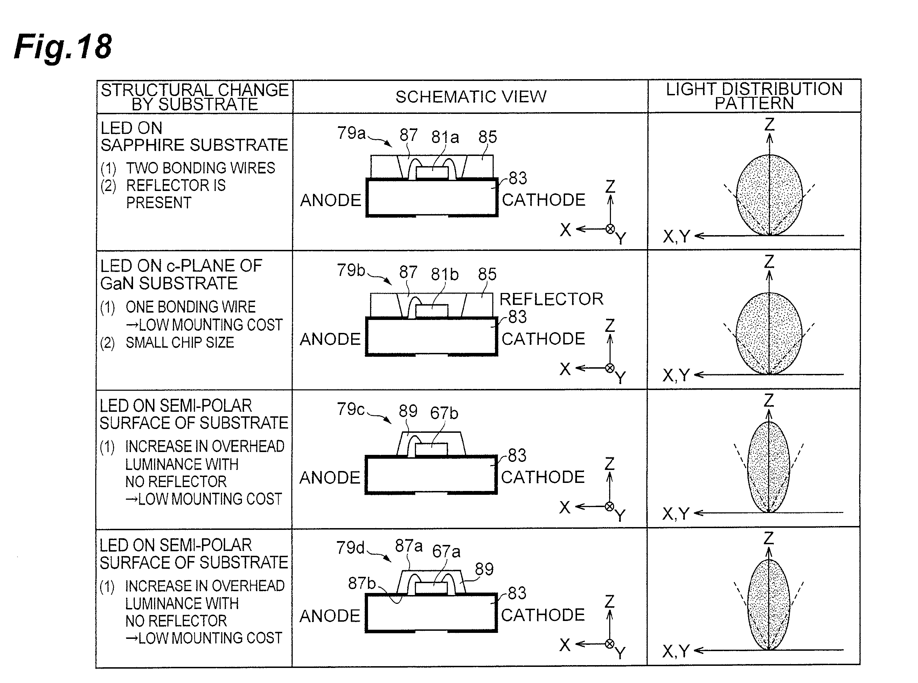

Fig. 18 is a diagram showing the configuration of a light emitting apparatus including the nitride-based semiconductor light emitting device according to this embodiment. Fig. 18 shows light emitting apparatuses 79a, 79b, 79c, and 79d. An LED device 81a using a sapphire substrate, an LED device 81b using a c-plane GaN substrate, and LED devices 67a and 67b using an off-axis GaN substrate are mounted on a support base 83. In order to direct outgoing from the side surfaces of the LED devices 81a and 81b toward the upper surface, a reflector 85 is mounted on the support base 83. A seal resin 87 is provided between the LED devices 81a and 81b and the reflector 85 so as to cover the LED devices 81a and 81b. Light from the LED devices 81a and 81b transmits the resin 87. The LED devices 67a and 67b using an off-axis GaN substrate have large overhead luminance. A seal resin 89 is provided so as to cover the LED devices 67a and 67b. Light from the LED devices 67a and 67b transmits the resin 89. With the light emitting apparatuses 79c and 79d, over head luminance can be increased without using the reflector 85.

With regard to the spread of the light distribution pattern of Fig. 18, the spread of the light emitting apparatuses 79c and 79d with no reflector is smaller than the spread of the light emitting apparatuses 79a and 79b.

In the light emitting apparatuses 79c and 79d, the rear surface of the resin 89 has a first portion 89b which is in contact with a support base 83, and a second portion 89a which is exposed without being in contact with the support base 83. With the light emitting apparatuses 79c and 79d, the first portion 89b is in contact with the support base 83, and the second portion 89a is exposed without being in contact with the support base, so the resin 89 does not include a reflector other than the support base 83.

Although in the preferred embodiment, the principle of the invention has been shown and described, it is understood by those skilled in the art that changes to the arrangement and details may be made without departing from the principle. The invention is not limited to a specific configuration described in this embodiment. It is intended therefore that the appended claims encompass any such modifications and changes.

### Industrial Applicability

With regard to improvement in light extraction efficiency of a light emitting diode, in the case of c-plane GaN substrate, it is not enough to roughen the rear surface by alkali etching, and various coatings or reflecting films are studied. However, like this embodiment, the off-axis GaN substrate is used as the base GaN substrate, so the rear surface is roughened by very simple alkali etching, such that the light extraction efficiency can be significantly improved. That is, the manufacturing process of a light emitting diode device can be simplified and costs can be significantly reduced. In particular, in this embodiment, overhead luminance of an LED device can be significantly increased, and if such an LED device is used for a side edge-type liquid crystal display or the like, it is an advantageous in that the light use efficiency can be significantly increased.

### Reference Signs List

11 : nitride-based semiconductor light emitting device, 13 : support base, 13a : principal surface of support base, 13b : rear surface of support base, 15 : semiconductor laminate, 15a : upper surface of semiconductor laminate, 15b : mesa region, 15c : exposed region, 17 : n-type gallium nitride-based semiconductor region, 19 : active layer, 21 : p-type gallium nitride-based semiconductor region, 23 : protrusion, M : surface morphology, VC : vector of c-axis, LB, LF, LR : light, Sc : c-plane, 27, 29 : electrode, 31, 33 : gallium nitride-based semiconductor layer, 35, 37 : gallium nitride-based semiconductor layer,

## Claims

1. A nitride-based semiconductor light emitting device comprising:
a support base including a hexagonal gallium nitride semiconductor, the support base having a principal surface and a rear surface; and
a semiconductor laminate including a p-type gallium nitride-based semiconductor region, an n-type gallium nitride-based semiconductor region, and an active layer,
wherein the rear surface of the support base is inclined with respect to a plane orthogonal to a reference axis extending in the c-axis direction of the hexagonal gallium nitride semiconductor,
a surface morphology of the rear surface has a plurality of protrusions protruding in the direction of the reference axis,
the active layer is provided between the p-type gallium nitride-based semiconductor region and the n-type gallium nitride-based semiconductor region,
the p-type gallium nitride-based semiconductor region, the active layer, and the n-type gallium nitride-based semiconductor region are arranged on the principal surface of the support base in the direction of a predetermined axis to form a semiconductor laminate, and
the direction of the predetermined axis is different from the direction of the reference axis.

2. The nitride-based semiconductor light emitting device according to claim 1,
wherein the principal surface of the support base is inclined at an angle in a range of not less than 10° and not more than 80° with respect to a <0001>-axis of the hexagonal gallium nitride semiconductor and at an angle in a range of not less than 10° and not more than 80° with respect to a <000-1>-axis of the hexagonal gallium nitride semiconductor, and
the rear surface of the support base is inclined at an angle in a range of not less than 10° and not more than 80° with respect to the <000-1>-axis of the hexagonal gallium nitride semiconductor and at an angle in a range of not less than 10° and not more than 80° with respect to the <0001>-axis of the hexagonal gallium nitride semiconductor.

3. The nitride-based semiconductor light emitting device according to claim 1 or 2,
wherein the principal surface of the support base is inclined at an angle in a range of not less than 10° and not more than 80° with respect to the <0001>-axis of the hexagonal gallium nitride semiconductor, and
the rear surface of the support base is inclined at an angle in a range of not less than 10° and not more than 80° with respect to the <000-1>-axis of the hexagonal gallium nitride semiconductor.

4. The nitride-based semiconductor light emitting device according to any one of claims 1 to 3,
wherein the principal surface of the support base is inclined at an angle in a range of not less than 55° and not more than 80° with respect to the <0001>-axis of the hexagonal gallium nitride semiconductor, and
the rear surface of the support base is inclined at an angle in a range of not less than 55° and not more than 80° with respect to the <000-1>-axis of the hexagonal gallium nitride semiconductor.

5. The nitride-based semiconductor light emitting device according to claim 1 or 2,
wherein the principal surface of the support base is inclined at an angle in a range of not less than 10° and not more than 80° with respect to the <000-1>-axis of the hexagonal gallium nitride semiconductor, and
the rear surface of the support base is inclined at an angle in a range of not less than 10° and not more than 80° with respect to the <0001>-axis of the hexagonal gallium nitride semiconductor.

6. The nitride-based semiconductor light emitting device according to any one of claims 1 to 3,
wherein the principal surface of the support base is inclined at an angle in a range of not less than 55° and not more than 80° with respect to the <000-1>-axis of the hexagonal gallium nitride semiconductor, and
the rear surface of the support base is inclined at an angle in a range not less than 55° and not more than 80° with respect to the <0001>-axis of the hexagonal gallium nitride semiconductor.

7. The nitride-based semiconductor light emitting device according to claim 1 or 2,
wherein the arithmetic mean roughness of the rear surface is not less than 0.5 µm and not more than 10 µm.

8. The nitride-based semiconductor light emitting device according to any one of claims 1 to 7,
wherein an apex portion of each of the protrusions has a hexagonal pyramid shape.

9. The nitride-based semiconductor light emitting device according to any one of claims 1 to 8,
wherein the semiconductor laminate has a partially exposed region in one of the p-type gallium nitride-based semiconductor region and the n-type gallium nitride-based semiconductor region, and
the nitride-based semiconductor light emitting device further includes a first electrode provided on the exposed region, and a second electrode provided on the other one of the p-type gallium nitride-based semiconductor region and the n-type gallium nitride-based semiconductor region in the semiconductor laminate.

10. The nitride-based semiconductor light emitting device according to any one of claims 1 to 8, further comprising:
a first electrode provided on the semiconductor laminate;
a second electrode provided on the rear surface of the support base.

11. The nitride-based semiconductor light emitting device according to any one of claims 1 to 10,
wherein the active layer is provided so as to have a peak wavelength in a wavelength range of not less than 350 nm and not more than 650 nm.

12. The nitride-based semiconductor light emitting device according to any one of claims 1 to 11,
wherein the active layer is provided so as to have a peak wavelength in a wavelength range of not less than 450 nm and not more than 650 nm.

13. A method of manufacturing a surface emission-type nitride-based semiconductor light emitting device, the method comprising the steps of:
preparing a substrate product including a substrate having a principal surface and a rear surface and a semiconductor laminate provided on the principal surface of the substrate; and
etching the rear surface of the substrate in the substrate product to form a processed surface having a surface morphology with a plurality of protrusions,
wherein the substrate includes a hexagonal gallium nitride semiconductor,
the rear surface of the substrate is inclined with respect to a plane orthogonal to a reference axis extending in the c-axis direction of the hexagonal gallium nitride semiconductor,
the protrusions protrude in the direction of the reference axis,
the semiconductor laminate has a p-type gallium nitride-based semiconductor region, an n-type gallium nitride-based semiconductor region, and an active layer,
the active layer is provided between the p-type gallium nitride-based semiconductor region and the n-type gallium nitride-based semiconductor region,
the p-type gallium nitride-based semiconductor region, the n-type gallium nitride-based semiconductor region, and the active layer are arranged on the principal surface of the substrate in the direction of a predetermined axis so as to form a semiconductor laminate, and
the direction of the predetermined axis is different from the direction of the reference axis.

14. The method according to claim 13,
wherein the rear surface of the substrate is inclined at an angle in a range of not less than 10° and not more than 80° with respect to a <000-1>-axis of the hexagonal gallium nitride semiconductor and at an angle in a range of not less than 10° and not more than 80° with respect to a <0001>-axis of the hexagonal gallium nitride semiconductor.

15. The method according to claim 13 or 14,
wherein the rear surface of the substrate is inclined at an angle in a range of not less than 10° and not more than 80° with respect to the <000-1 >-axis of the hexagonal gallium nitride semiconductor.

16. The method according to any one of claims 13 to 15, wherein the rear surface of the substrate is inclined at an angle in a range of not less than 55° and not more than 80° with respect to the <000-1 >-axis of the hexagonal gallium nitride semiconductor.

17. The method according to claim 13 or 14,
wherein the rear surface of the support base is inclined at an angle in a range of not less than 10° and not more than 80° with respect to the <0001>-axis of the hexagonal gallium nitride semiconductor.

18. The method according to any one of claims 13, 14, and 17,
wherein the principal surface of the support base is inclined at an angle in a range of not less than 55° and not more than 80° with respect to the <000-1>-axis of the hexagonal gallium nitride semiconductor, and
the rear surface of the support base is inclined at an angle in a range of not less than 55° and not more than 80° with respect to the <0001>-axis of the hexagonal gallium nitride semiconductor.

19. The method according to claim 13 or 14,
wherein the processed surface is formed by wet etching.

20. The method according to any one of claims 13 to 19,
wherein the processed surface is formed by alkali solution.

21. The method according to any one of claims 13 to 20,
wherein an apex portion of each of the protrusions has a hexagonal pyramid shape.

22. The method according to any one of claims 13 to 21,
wherein the arithmetic mean roughness of the rear surface is not less than 0.5 µm and not more than 10 µm.

23. The method according to any one of claims 13 to 22, further comprising the steps of:
forming a first electrode on the processed surface of the substrate; and
forming a second electrode on the semiconductor laminate.

24. The method according to any one of claims 13 to 22,
wherein the semiconductor laminate has a partially exposed region in one of the p-type gallium nitride-based semiconductor region and the n-type gallium nitride-based semiconductor region, and
the method further includes a step of:
forming a first electrode on the exposed region and forming a second electrode on the other one of the p-type gallium nitride-based semiconductor region and the n-type gallium nitride-based semiconductor region in the semiconductor laminate.

25. The method according to claim 24, further comprising the steps of:
growing one p-type gallium nitride-based semiconductor layer or a plurality of p-type gallium nitride-based semiconductor layers, one n-type gallium nitride-based semiconductor layer or a plurality of n-type gallium nitride-based semiconductor layers, and an active layer on the principal surface of a gallium nitride semiconductor wafer to form an epitaxial wafer; and
etching the epitaxial wafer to form the semiconductor laminate,
wherein the p-type gallium nitride-based semiconductor layers, the n-type gallium nitride-based semiconductor layers, and the active layer are arranged on the principal surface of the gallium nitride semiconductor wafer in the direction of a predetermined axis, and
the principal surface of the gallium nitride semiconductor wafer is inclined at an angle in a range of not less than 10° and not more than 80° with respect to a <0001>-axis of the hexagonal gallium nitride semiconductor.

26. The method according to claim 25, further comprising a step of:
grinding the rear surface of the gallium nitride semiconductor wafer to form the substrate of the substrate product.

27. The method according to any one of claims 13 to 26,
wherein the maximum value of the distance between two points on the edge of the substrate is not less than 45 mm.

28. A light emitting apparatus comprising:
the nitride-based semiconductor light emitting device according to any one of claims 1 to 12;
a support base having a support surface supporting the rear surface of the nitride-based semiconductor light emitting device; and
a resin provided on the nitride-based semiconductor light emitting device and the support base to seal the nitride-based semiconductor light emitting device,
wherein light from the nitride-based semiconductor light emitting device transmits the resin.

29. The light emitting apparatus according to claim 28,
wherein the surface of the resin has a first portion which is in contact with the support base and a second portion which is exposed without being in contact with the support base.
